# EUROPÄISCHE PATENTSCHRIFT

(11) **EP 1 514 347 B1**
(45) Veröffentlichungstag und Bekanntmachung des Hinweises auf die Patenterteilung: **16.11.2011**
(21) Anmeldenummer: 03759867.9
(22) Anmeldetag: 18.06.2003
(51) Int. Cl.: H03H 17/02

(54) **VERFAHREN ZUR DIGITALEN FILTERUNG**
DIGITAL FILTERING METHOD
PROCEDE DE FILTRAGE NUMERIQUE

(30) Priorität: 18.06.2002 DE 10250607
(43) Veröffentlichungstag der Anmeldung: 16.03.2005
(73) Patentinhaber: Automotive Distance Control Systems GmbH, 88131 Lindau (DE)
(72) Erfinder: WINTERMANTEL, Markus, 88131 Lindau (DE)
(74) Vertreter: Grau, Ulf
(86) Internationale Anmeldenummer: PCT/DE2003/002050
(87) Internationale Veröffentlichungsnummer: WO 2003/107533

(56) Entgegenhaltungen:
- EP-A2- 0 295 464
- LEE C L ET AL: "BIT-SLICED MEDIAN FILTER DESIGN BASED ON MAJORITY GATE" IEE PROCEEDINGS G. ELECTRONIC CIRCUITS & SYSTEMS, INSTITUTION OF ELECTRICAL ENGINEERS. STEVENAGE, GB, Bd. 139, Nr. 1, 1. Februar 1992 (1992-02-01), Seiten 63-71, XP000293218 ISSN: 0622-0039
- ATAMAN ET AL: "A fast method for real-time median filtering" IEEE TRANSACTIONS ON ACOUSTICS,SPEECH AND SIGNAL PROCESSING, Bd. 28, Nr. 4, August 1980 (1980-08), Seiten 415-421, XP001160948 NEW YORK US
- BARUN K. KAR; DHIRAJ K. PRADHAN: "A New Algorithm for Order Statistic and Sorting", IEEE TRANSACTIONS ON SIGNAL PROCESSING, vol. 41, no. 8, August 1993 (1993-08), pages 2688-2694, USA

## Beschreibung

Die Erfindung betrifft ein Verfahren zur digitalen Filterung von K digitalen Eingangswerten, welche i. Allg. benachbarte Werte eines ein- oder mehrdimensionalen digitalen Signals darstellen, wobei das Filter nichtlinear ist und als Ausgangswert den R-größten Wert aus den K Eingangswerten bestimmt, wobei R und K ganzzahlig sind und K ≥ R ≥ 1 gilt. Ein solches Filter soll nachfolgend Rangfilter genannt, wobei R=1 dem größten der Eingangswerte und R=K dem kleinsten der Eingangswerte entspricht. Ein eindimensionales Rangfilter berechnet zu jedem Zeitpunkt m = L·n den R-größten Wert von K aufeinanderfolgenden Werten eines Eingangssignals x(n); für L = 1 handelt es sich um ein Filter ohne Dezimation, d. h. ohne Reduktion der Abtastrate, für L > 1 um ein Filter mit Dezimation. Analog dazu ermittelt ein mehrdimensionales Rangfilter den R-größten Wert von K benachbarten Werten eines mehrdimensionalen Signals. Der R-größte Eingangswert entspricht dabei selbstverständlich dem (K-R)-kleinsten Eingangswert, so dass das Verfahren synonym auch die Bestimmung eines x-kleinsten Eingangswertes umfasst, in dem der R=K-x-größte Wert gesucht wird.

Ein Spezialfall eines solchen Rangfilters ist ein Medianfilter. Unter dem Median von einer ungeraden Zahl K an Eingangswerten versteht man den mittleren Wert, d. h. den (K+1)/2-kleinsten Wert oder, was identisch ist, den (K+1)/2-größten Wert, was i. Allg. unterschiedlich zum Mittelwert ist. Zum Beispiel ergibt sich für die fünf Werte 5, 3, 2, 79 und 1 der Median 3, als Mittelwert jedoch der Wert 18.

Derartige digitale Filter dienen der Signalverarbeitung von gewonnenen Eingangswerten, bspw. der Aufbereitung von Bilddaten oder Entfernungsmesssignalen, insbesondere auch Reflexionssignalen von in einem Zielgebiet reflektierten Impulsen, wobei optische Wellen, vorzugsweise im Infrarotbereich, Radarwellen oder Ultraschallwellen in Betracht kommen. Eine Realisierung von derartigen nichtlinearen Filtern ist nur im digitalen Bereich möglich.

Für die Implementierung von derartigen Filtern sind Algorithmen bekannt, welche meist auf Sortierverfahren basieren, die sehr rechenaufwendig sind, oder auf Histogrammverfahren, die einen hohen Speicherbedarf haben, und sich i. Allg. eher für eine Software- als für eine Hardware-Realisierung eignen.

Weiterhin sind im Stand der Technik Verfahren bekannt, die zur Medianfilterung binärer Zahlen auf Bit-Ebene geeignet sind. Diese Verfahren bestimmen den Median von einer Anzahl von Eingangswerten, indem sukzessive die einzelnen Bitwerte der Eingangswerte beginnend mit dem Most significant bit (MSB) betrachtet und daraus der Median Bit für Bit bestimmt wird. Ein solches Verfahren wurde z.B. von Lee et al. "Bit sliced median filter design based on majority gate" (veröffentlicht in IEEE Proceedings G. Electronic Circuits & Systems, Institution of Electrical Engeneers. Stevenage, GB, Bd. 139, Nr. 1, 1. Februar 1992, S. 63-67, Atman et al. "A Fast Method for real time median filtering" (veröffentlicht in IEEE transactions on Acoustics, Speech and Signal Processing, Bd.28, Nr.4, August1989, S. 415-421*)*, Barun K. Kar et al. " A new Algorithm for Order Statistic and Sorting" (veröffentlicht in IEEE transactions on Signal Processing, Bd.41, Nr.8, August1993, S. 2688-2694*)* und in der EP0295464 beschrieben.

Nachteilig an den beschriebenen Verfahren zur Medianfilterung binärer Zahlen auf Bit-Ebene ist, dass die Eingangswerte kein Vorzeichen aufweisen dürfen.

Aufgabe der Erfindung ist es daher, ein neuartiges Verfahren zur digitalen Rangfilterung vorzustellen, welches einfach und kostengünstig realisierbar und auf vorzeichenbehaftete Werte in Binärdarstellung anwendbar ist. Diese Aufgabe wird durch die Merkmale der unabhängigen Ansprüche 1 und 3 gelöst. Vorteilhafte Weiterbildungen sind den Unteransprüchen zu entnehmen.

Grundgedanke ist dabei zum einen die Verwendung einer binären Darstellung der Eingangswerte in Festkommaformat und zum anderen eine bitserielle Abarbeitung, wobei sich alle üblichen binären Zahlendarstellungen in Festkommaformat verwenden lassen und nur geringfügige Anpassungen unter Berücksichtigung der jeweiligen Eigenheiten der verwendeten Zahlendarstellung erforderlich sind. Der Anspruch 1 beinhaltet den Ablauf der Filterung unter Berücksichtigung aller wichtigen binären Zahlendarstellungen in Festkommaformat und weist in Abhängigkeit von der jeweils vorliegenden Zahlendarstellung entsprechende Schrittalternativen auf, die aber auf dem gleichem Grundgedanken beruhen. Eine Reihe von Unteransprüchen zeigt dabei auf, wie sich der Filterablauf für bestimmte Zahlendarstellungen der Eingangswerte deutlich vereinfacht.

Zudem werden vorteilhafte Weiterbildungen zur hardwaretechnischen Umsetzung des digitalen Filters z. B. in einem FPGA oder einem ASIC vorgestellt, die eine hohe Verarbeitungsgeschwindigkeit ermöglichen, wie dies für die Bildverarbeitung oder Radaranwendungen in Kraftfahrzeugen erforderlich ist.

Die Erfindung wird nachfolgend anhand von Ausführungsbeispielen und Figuren näher erläutert.

Die Figuren zeigen:

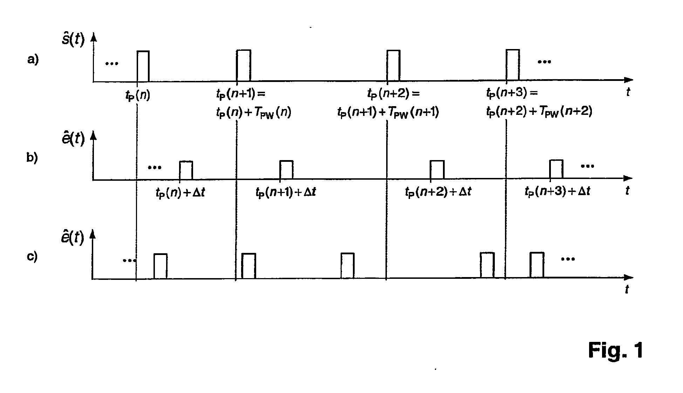

- Fig. 1 a):: Amplitude bzw. Einhüllende ŝ(t) der ausgesendeten Welle für den Fall von rechteckförmigen Impulsen
- Fig. 1 b):: Amplitude bzw. Einhüllende ê(t) der empfangenen Welle für den Fall eines Objekts in der Entfernung a, welche in einer Signallaufzeit von Δt = 2a/c resultiert
- Fig. 1c):: gestörtes Empfangssignal ê(t), bspw. wegen Überreichweiten oder Interferenzen von einem anderen gepulsten, im selben Frequenzbereich arbeitenden System
- Fig. 2a):: Sinusschwingung im diskreten Zeitbereich, welcher zahlreiche hohe Störimpulse überlagert sind; im Spektrum des resultierenden Signals ist der spektrale Peak der Sinusschwingung in dem von den Störimpulsen erzeugten Rauschen verschwunden
- Fig. 2b):: Ausgangssignal nach zweistufiger Medianfilterung mit jeweiliger Filterlänge K = 5, bei dem die Sinusschwingung im Zeitbereich fast vollständig wieder rekonstruiert und im Spektrum somit deutlich sichtbar ist
- Figur 3: Blockschaltbild eines Puls-Doppler-Radarsystems
- Figur 4: vereinfachtes Schaltbild zur Erläuterung des Prinzip des Doppler-Verfahrens;
- Figur 5: die Signal-Zeit-Diagramme für das Schaltbild nach Figur 4;
- Figur 6: die Übertragungsfunktion eines idealen und eines realen Optimalfilters;
- Figur 7: das Schaltbild eines ersten Ausführungsbeispiels eines Optimalfilters;
- Figur 8: das Schaltbild eines zweiten, bevorzugten Ausführungsbeispiels eines Optimalfilters;
- Fig.9a: Algorithmus zur Implementierung eines Median-Filters mit einer bitserielle Abarbeitung für Binärdaten in vorzeichenloser Binärdarstellung
- Fig.9b: Algorithmus zur Implementierung eines Median-Filters mit einer bitserielle Abarbeitung für Binärdaten in Vorzeichen-Betrags-Darstellung
- Fig.9c: Algorithmus zur Implementierung eines Median-Filters mit einer bitserielle Abarbeitung für Binärdaten in Einer- oder Zweier-Komplement-Darstellung
- Fig.10a,b,c: Detail jeweils zu den Fig.9a,9b,9c
- Figur 11: die Übertragungsfunktion eines idealen und eines realen Dezimationstiefpasses;
- Figur 12: die Impulsantwort h(n) eines gleitenden Mittelwertbildners sowie ein Signalflussdiagramm;
- Figur 13: ein vorteilhaftes Ausführungsbeispiels eines Dezimationstiefpasses.

Das Verfahren zur digitalen Filterung soll zunächst anhand eines einfachen Beispiels einer Bestimmung des Median von 5 Eingangswerten erläutert werden. Dazu seien die nachfolgenden fünf Zahlen in vorzeichenloser Binärdarstellung und mit der Wortlänge W = 4 (4 binäre Ziffern) betrachtet; dabei bezeichnet das Bit 0 das höchststignifikante Bit MSB (most significant bit) und das Bit 3 das niedersignifikanteste Bit LSB (least significant bit):

| | Bit | 0 | 1 | 2 | 3 |
|---|---|---|---|---|---|
| Zahl | | | | | |
| a | | 1 | 1 | 1 | 1 |
| b | | 1 | 0 | 1 | 0 |
| c | | 1 | 1 | 1 | 1 |
| d | | 0 | 0 | 0 | 0 |
| e | | 1 | 0 | 0 | 0 |

Für die einzelnen Bits werden in absteigender Bitwertigkeit beginnend mit einem höchstsignifikanten Bit (MSB) nacheinander bis zum niedersignifikantesten Bit (LSB) folgende Schritte durchgeführt:
- beim jeweils aktuell betrachteten Bit wird über alle 5 Eingangswerte gesehen der mittlere, also 3-größte Bitwert bestimmt, welcher 1 ist, falls beim aktuell betrachteten Bit über alle 5 Eingangswerte gesehen nicht weniger als 3-mal der Wert 1 auftritt, ansonsten ist der R-größte Bitwert 0,
- wobei der 3-größte Bitwert dann den Bitwert für das aktuell betrachtete Bit des 3-größten Werts und damit des Ausgangswertes, also des Median darstellt,
- und für diejenigen Eingangswerte, bei welchen der Bitwert des aktuell betrachteten Bits nicht dem 3-größten Bitwert entspricht, als Bitwerte aller nachfolgenden, d. h. niederwertigeren Bits, derjenige Bitwert dieser Eingangswerte am aktuell betrachteten Bit betrachtet werden.

Das MSB (Bit 0) des Median muss 1 sein, da die Mehrheit der fünf MSBs gleich 1 ist; vier MSBs sind 1 und die zugehörigen Zahlen a, b, c und e somit größer als die Zahl d mit dem MSB 0, so dass eine der Zahlen mit dem MSB 1 der Median sein muss. Die übrigen Bits 1...3 des Median ergeben sich somit als drittgrößter der durch die Bits 1...3 dargestellten Werte der vier Zahlen mit dem MSB 1. Ersetzt man bei der Zahl d mit dem MSB 0 die Bits 1...3 durch den minimal darstellbaren Wert **000** (siehe nachfolgende Tabelle) und betrachtet alle fünf Zahlen, dann ergeben sich die Bits 1...3 des Median weiterhin als drittgrößter der durch die Bits 1...3 dargestellten Werte **-** nun aber aller Zahlen - und somit als Median dieser Werte.

| | Bit | 0 | 1 | 2 | 3 |
|---|---|---|---|---|---|
| Zahl | | | | | |
| a | | | 1 | 1 | 1 |
| b | | | 0 | 1 | 0 |
| c | | | 1 | 1 | 1 |
| d | | | **0** | **0** | **0** |
| e | | | 0 | 0 | 0 |
| | | | | | |
| **Median** | | **1** | | | |

Somit hat man das Problem auf die Medianbildung von weiterhin fünf Zahlen, aber mit um eins reduzierter Wortlänge 3 zurückgeführt - diese Zahlen sind in obiger, modifizierter Tabelle dargestellt (das nicht mehr zu betrachtende MSB ist durchgestrichen). Um das Bit 1 des Median zu bestimmen, ist wieder nur zu prüfen, ob beim Bit 1 mehr Nullen oder Einsen auftreten; demzufolge ist das Bit 1 des Median gleich 0. Eine der drei Zahlen b, d und e mit dem Bit 1 gleich 0 muss bezüglich den Bits 1...3 den Median darstellen, da die zwei Zahlen a und c mit Bit 1 gleich 1 größer sind. Die übrigen Bits 2...3 des Median ergeben sich somit als drittkleinster der durch die Bits 2...3 dargestellten Werte der drei Zahlen b, d und e mit dem Bit 1 gleich 0. Ersetzt man bei den Zahlen a und c mit Bit 1 gleich 1 die Bits 2...3 durch den maximal darstellbaren Wert 11 (siehe nachfolgende Tabelle) und betrachtet alle fünf Zahlen, dann ergeben sich die Bits 2...3 des Median weiterhin als drittkleinster der durch die Bits 2...3 dargestellten Werte - nun aber aller Zahlen - und somit als Median dieser Werte.

| | Bit | 0 | 1 | 2 | 3 |
|---|---|---|---|---|---|
| Zahl | | | | | |
| a | | | | 1 | 1 |
| b | | | | 1 | 0 |
| c | | | | 1 | 1 |
| d | | | | **0** | **0** |
| e | | | | 0 | 0 |
| | | | | | |
| **Median** | | **1** | **0** | | |

Die für die Medianbildung zu betrachtende Wortlänge ist somit weiter um eins reduziert worden - es ist nur noch der Median der oben dargestellten fünf Zahlen mit Wortlänge 2 zu bilden, wobei analog zu den vorhergehenden Schritten vorzugehen ist. Da im Bit 2 die Einsen überwiegen, ergibt sich das Bit 2 des Median zu 1. Bei den zwei Zahlen d und e mit Bit 2 gleich 0 ist das Bit 3 durch den minimal darstellbaren Wert 0 zu ersetzen (siehe nachfolgende Tabelle). Bei der Zahl d wäre das nicht notwendig, da dieses Bit schon in einem früheren Schritt entsprechend modifiziert wurde.

| | Bit | 0 | 1 | 2 | 3 |
|---|---|---|---|---|---|
| Zahl | | | | | |
| a | | | | | **1** |
| b | | | | | **0** |
| c | | | | | **1** |
| d | | | | | **0** |
| e | | | | | **0** |
| | | | | | |
| **Median** | | **1** | **0** | **1** | |

Da zu diesem Zeitpunkt bereits 4 (a,c,d,c) der 5 Eingangswerte modifiziert und somit nicht als mit dem Median übereinstimmend erkannt wurden, ergibt sich als Median bereits erkennbar der Wert von b und könnte der Prozess bereits abgebrochen werden. Ein derartiges Abbruchkriterium ist jedoch zusätzlicher Aufwand, so dass es eventuell einfacher ist, die Schrittfolge auch noch für die nachfolgenden Bits, hier das LSB durchzuführen. Da beim Bit 3 (LSB) die Nullen überwiegen, ergibt sich das LSB des Median zu 0 (siehe nachfolgende Tabelle).

| | Bit | 0 | 1 | 2 | 3 |
|---|---|---|---|---|---|
| Zahl | | | | | |
| a | | | | | |
| b | | | | | |
| c | | | | | |
| d | | | | | |
| e | | | | | |
| | | | | | |
| **Median** | | **1** | **0** | **1** | **0** |

Damit ist der Median vollständig und richtig bestimmt; der berechnete Wert 1010 stimmt mit der drittgrößten Zahl b der Ausgangswerte überein.

Der zugrundeliegende Algorithmus zur Bestimmung des Median von K Zahlen soll nun für den Fall der vorzeichen losen Binärdarstellung in allgemeiner Weise formuliert werden:

Die einzelnen Bits sind beginnend beim MSB bis hin zum LSB der Reihe nach wie folgt abzuarbeiten. Zuerst ist zu untersuchen, ob beim betrachteten Bit b über alle K Zahlen gesehen mehr Einsen oder Nullen auftreten; der häufiger auftretende Bitwert stellt das Bit b des Median dar. Für die Zahlen, bei welchen das Bit b dem weniger oft auftretenden Bitwert entspricht, sind alle nachfolgenden, d. h. niederwertigeren Bits gleich dem Bit b zu setzen.

Für die anderen meistgebräuchlichen Binärdarstellungen unterscheidet sich nur die Bedeutung des ersten Bits gegenüber der bisher betrachteten vorzeichen losen Binärdarstellung; bei der Einer- und Zweierkomplementdarstellung ist das erste Bit weiterhin das MSB - aber mit anderer Wertigkeit, bei der Vorzeichen-Betrag-Darstellung ist das erste Bit das Vorzeichenbit (VZB), welches vom MSB des Betrags gefolgt wird. Damit ergibt sich bei der sequentiellen Abarbeitung der Bits nur beim ersten Bit ein Unterschied, während alle nachfolgenden Bits unverändert, wie oben beschrieben, zu behandeln sind. Auch die Bestimmung des ersten Bits des Median bleibt unverändert; es entspricht immer dem häufiger auftretenden Bitwert bei dem ersten Bit der K Zahlen. Einzig die Modifikation der Zahlen mit dem weniger oft auftretenden ersten Bitwert ist unterschiedlich; abhängig davon, ob diese Zahlen nicht über oder unter dem Median liegen, ist für ihre nachfolgenden Bits immer der mit diesen Bits darstellbare minimale oder maximale Wert zu verwenden - bei der Vorzeichen-Betrag-Darstellung jedoch bzgl. einer Interpretation mit dem Median-Vorzeichen. Im Fall der Einer- und Zweierkomplementdarstellung sind für die Zahlen mit dem weniger oft auftretenden MSB-Wert alle nachfolgenden Bits gleich dem inversen MSB-Wert zu setzen; im Fall der Vorzeichen-Betrag-Darstellung sind für die Zahlen mit dem weniger oft auftretenden VZB-Wert alle nachfolgenden Bits gleich 0 zu setzen.

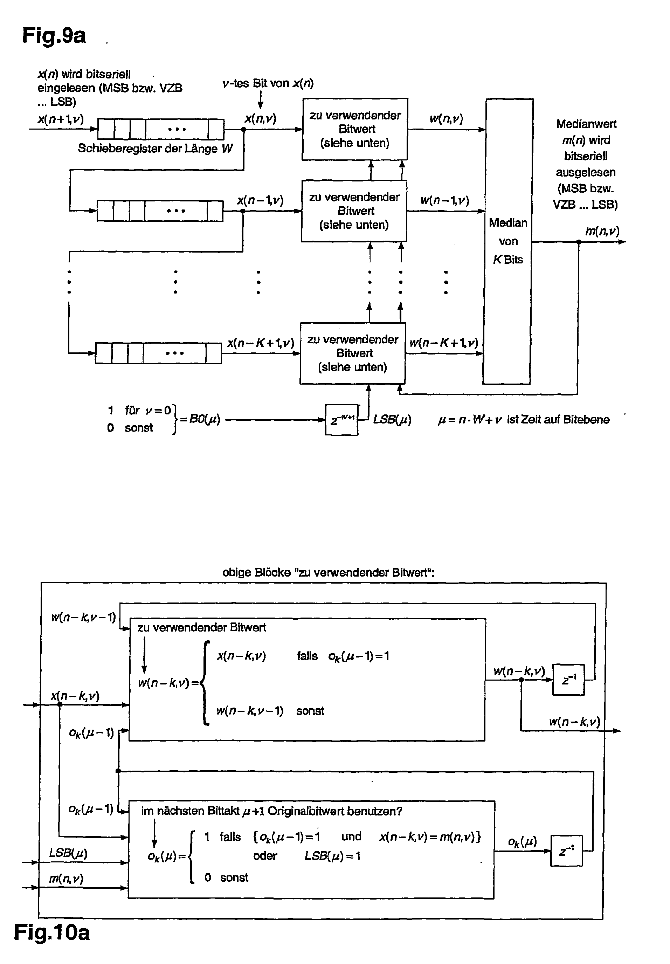

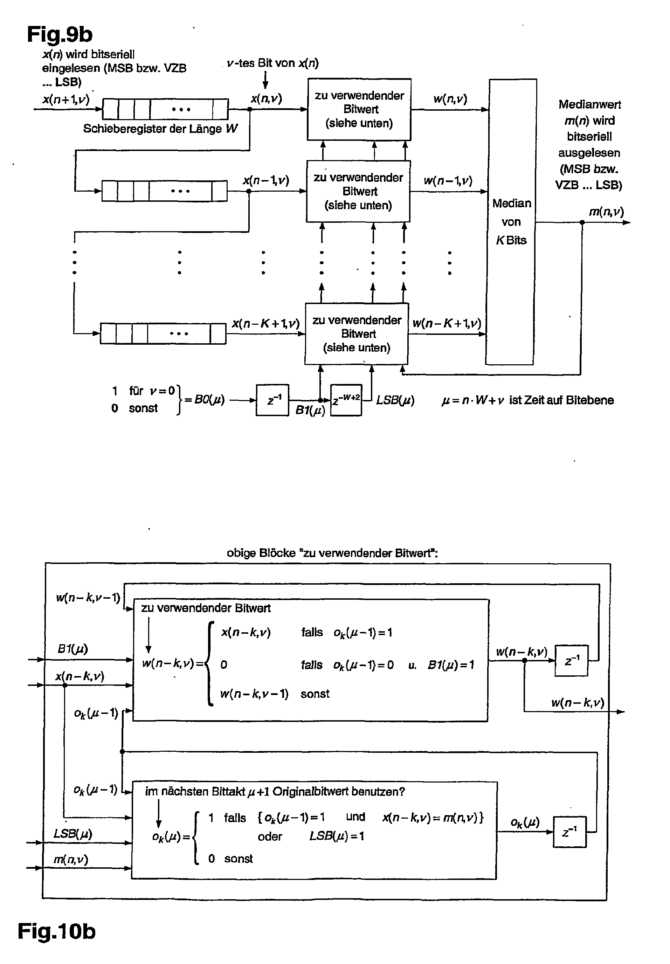

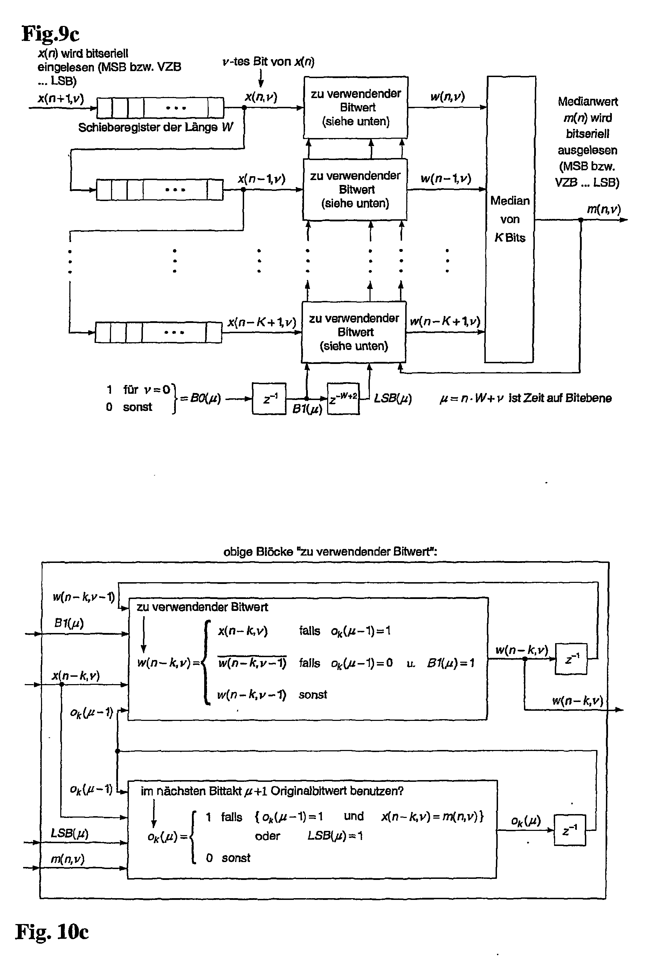

In den Figuren 9a,9b,9c sowie den Fig.10a,10b,10c sind Varianten des Filteralgorithmus zur Medianberechnung in Form eines eindimensionalen Filters ohne Dezimation dargestellt, wobei die Fig.9a in Verbindung mit Fig.10a den Aufbau für Eingangswerte in vorzeichenloser Binärdarstellung zeigen, während die Fig.9b in Verbindung mit Fig.10b die Abwandlung für eine Vorzeichen-Betrags-Darstellung der Eingangswerte und die Fig.9c in Verbindung mit Fig.10c die Abwandlung für eine Einer- oder Zweier-Komplement-Darstellung der Eingangswerte verdeutlichen. Zur Erläuterung seien folgende Punkte angemerkt:

Das Eingangssignal x(n) und das Ausgangssignal bestehend aus den Medianwerten m(n) besitzen die Wortlänge W, d. h. jeder Zeitwert besteht aus W Bits. Die einzelnen Bits werden mit v nummeriert, beginnend bei v = 0 für das MSB (bei vorzeichenloser Binärdarstellung in Fig.9a,10a sowie Einer- und Zweierkomplementdarstellung in Fig.9c,10c) bzw. das VZB (bei Vorzeichen-Betrag-Darstellung in Fig.9b,10b) und endend bei ν = W-1 für das LSB. Das Bit ν von x(n) bzw. m(n) wird mit x(n,ν) bzw. m(n,ν) bezeichnet.

Die Zeit auf Ebene der Ein- und Ausgangssignale, d. h. Wortebene, wird mit n bezeichnet, die Zeit auf Bitebene mit µ = n·W +ν.

Die Verarbeitung ist bitseriell, d. h. ein Bit nach dem anderen wird bearbeitet, beginnend beim MSB bzw. VZB und endend beim LSB. Die gesamte Filterstruktur, d. h. Speicher und Logik, werden also mit der Bitzeit µ getaktet.

Die zur Medianberechnung benötigten Eingangswerte werden bitweise mit Hilfe von K aufeinanderfolgenden Schieberegistern der Länge W gespeichert; dabei ist K die Medianfilterlänge.

Das Flag B0(µ) kennzeichnet die Verarbeitung vom Bit 0; es ist 1 für ν = 0 und sonst 0. Die Flags B1(µ) und LSB(µ) kennzeichnen die Verarbeitung vom Bit 1 bzw. vom LSB; sie sind in analoger Weise definiert und lassen sich durch Verzögerung von B0(µ) um einen bzw. W-1 Takte generieren.

Im Block "Median von K Bits" findet die bitweise Medianbildung statt, d. h. die Majorität von Nullen oder Einsen unter den K eingespeisten Bits wird bestimmt.

Im k-ten Block "zu verwendender Bitwert" (k = 0,1,...,K-1 ist von oben gesehen), welcher im Detail jeweils in den Figuren 10a, 10b und 10c gezeigt ist, wird zum einen der k-te Bitwert w(n-k,ν) für die bitweise Medianbildung bestimmt: dies ist entweder der Originalwert x(n-k,ν), d. h. vom Eingangswert x(n-k) das betrachtete Bit ν, oder ein entsprechend modifizierter Wert. Zum anderen wird ermittelt, ob im nächsten Bittakt µ+1 der Originalwert oder ein entsprechend modifizierter Wert zu verwenden ist, was durch das Flag oₖ(µ) =1 für die bisher nicht erfolgte Modifizierung bzw. oₖ(µ) = 0 für die bereits erfolgte Modifizierung gekennzeichnet wird. Dabei ist die aus dem oben beschriebenen Vorgehen folgende Regel berücksichtigt, dass nach der ersten Verwendung eines modifizierten Wertes dieser auch nachfolgend bis zum Ende des jeweiligen Zeitschrittes n zu verwenden ist. Anschließend, d. h. bei LSB(µ)=1 wird das Flag wieder zurückgesetzt, d. h. für den nächsten Ausgangswert wird zunächst wieder der unmodifizierte Eingangswert berücksichtigt.

Die Initialisierung der Speicher (Schieberegister sowie Verzögerer) ist abhängig vom gewünschten Anlaufverhalten des Filters.

Im folgenden soll diese neue Medianfilterstruktur bzgl. ihres Aufwandes bei einer Hardware-Realisierung (z. B. auf einem ASIC oder FPGA) betrachtet werden:

Die bitweise Medianbildung, d. h. die Bestimmung der Majorität von Nullen oder Einsen unter den K eingespeisten Bits, ist zentraler Block dieser Struktur. Eine mögliche, insbesondere für größere Filterlängen K geeignete Strategie zur Realisierung dieses Blocks basiert auf der Summenbildung der Bitwerte (sind 0 oder 1). Ist die Bitsumme >= (K+1)/2, so ist der Bitmedian gleich 1, ansonsten 0; den Vergleich kann man über eine Subtraktion und anschließende Abprüfung auf das Vorzeichen implementieren. Die Bitsummenbildung kann z. B. in gestufter paralleler Form realisiert werden, bei welcher von Stufe zu Stufe die Zahl der parallelen Einzeladdierer ab- und ihre Wortlänge zunimmt; dadurch lassen sich einerseits der kritische Pfad und damit die benötigte Durchlaufzeit minimieren sowie andererseits die benötigten Wortlängen und damit der Aufwand möglichst klein halten. Die Minimierung des kritischen Pfads ist besonders dann wichtig, wenn eine hohe Taktzeit des Filters gefordert ist, da die bitweise Medianbildung in einer rekursiven Schleife liegt und deshalb ein Pipelining ausscheidet. Für kleine Filterlängen gibt es zur Realisierung der bitweisen Medianbildung spezielle, auf die benutzte Hardware optimierte Lösungen. Als Beispiel betrachtet sei die Filterlänge K = 5 und die Realisierung auf einem marktüblichen FPGA, welches als Grundbaustein Look-Up-Tables (LUTs) mit vier logischen Eingängen und einem logische Ausgang besitzt; es werden dann drei solcher LUTs für die bitweise Medianbildung benötigt.

Die K identischen Blöcke "zu verwendender Bitwert" benötigen jeweils nur zwei Verzögerer (FIFOs) sowie eine sehr einfache Logik (im obigem Beispiel 2 LUTs).

Die K Schieberegister zur Speicherung der Eingangswerte benötigen in vielen Fällen (insbesondere wenn die Wortlänge W relativ groß ist) wesentlich mehr Aufwand als der Rest der Filterstruktur, was für die Effizienz der Fifterlogik spricht. Es sei bemerkt, dass eine Speicherung von K Eingangswerten in jedem Medianfilter unabhängig von der Struktur notwendig ist.

Die neue Medianfilterstruktur ist skalierbar, sofern die bitweise Medianbestimmung über eine Summenbildung realisiert ist; bei Änderung der Filterlänge K sind nur die Zahl der verwendeten Schieberegister, die Zahl der identischen Blöcke "zu verwendender Bitwert" und die Zahl der aufzusummierenden Bits sowie der mit der Bitsumme zu vergleichende Wert anzupassen.

Die neue Medianfilterstruktur hat die Eigenschaft, dass die Medianbildung für jeden Eingangswert, d. h. jeden Zeitschritt n, ganz neu aufsetzt, also im Gegensatz zu den meisten gebräuchlichen Strukturen nicht auf Ergebnisse früherer Zeitschritte zurückgreift; beispielsweise wird bei Sortierverfahren i. Allg. von der im vorhergehenden Zyklus bestimmten Reihenfolge ausgegangen. Wegen dieser Eigenschaft eignet sich der neue Algorithmus zur Medianberechnung in ganz besonderem Maße für eine Filterung mit Dezimation. Dazu sind in der Filterstruktur nur die Schieberegister in modifizierter Weise zu speisen. So sind bei einer Dezimation um den Faktor L = 2 die zwei obersten Schieberegister parallel mit zwei aufeinanderfolgenden Eingangswerten zu speisen, und bei der Verkopplung der Schieberegister wird jeweils eins übersprungen. Bei einer Dezimation um die Medianfilterlänge, d. h. L = K, sind die Schieberegister nicht mehr verkoppelt, sondern werden parallel mit K aufeinanderfolgenden Eingangswerten gespeist. Durch Dezimation kann die von der Filterstruktur maximal prozessierbare Taktrate des Eingangssignals x(n) um den Dezimationsfaktor L erhöht werden.

Für Hardware-Realisierungen des digitalen Filters führt der neue Algorithmus zur Medianberechnung in vielen Fällen zu einer beträchtlichen Reduktion des benötigten Aufwands; dies ist hauptsächlich abhängig von der Taktrate sowie der Wortlänge des Eingangssignals, dem Grad der Dezimation und der verwendeten Technologie bzw. verfügbaren Logik.

Bisher wurden nur die meistgebräuchlichen binären Festkommadarstellungen (vorzeichenlose Binär-, Zweierkomplement-, Einerkomplement- oder Vorzeichen-Betrag-Darstellung) betrachtet. Für andere binäre Festkommadarstellungen lässt sich der neue Algorithmus zur Medianbildung in analoger Weise formulieren und geht auch aus der nachfolgenden Beschreibung für allgemeinere Rangfilter hervor.

Statt unter einer ungeraden Zahl K an Werten speziell den (K+1)/2-größten Wert zu deklarieren, kann man auch einen Wert mit anderem Rang, also ganz allgemein den R-größten Wert, R = 1,2,...,K, betrachten und dabei für K eine beliebige ganze Zahl zulassen. Das darauf basierende Filter wird im folgenden als Rangfilter bezeichnet; es berechnet also jeweils von K aufeinanderfolgenden bzw. benachbarten Werten eines ein- bzw. mehrdimensionalen Eingangssignals den R-größten Wert und wird z. B. bei einer geordneten Statistik (Ordered Statistic) benutzt.

Der oben vorgestellte neue Filteralgorithmus zur Medianbildung kann recht einfach auf eine allgemeinere Rangbildung erweitert werden, was auf nachfolgende Formulierung führt; dabei sind alle binären Zahlendarstellungen in Festkommaformat zulässig, bei welchen sich der Betrag der Bitwertigkeiten vom MSB zum LSB hin jeweils halbiert, nur die Bitwerte 0 und 1 vorkommen (also z. B. nicht -1 wie im CSD-Code) und es gegebenenfalls ein zusätzliches Vorzeichenbit (VZB) gibt:

Um die R-größte von K Zahlen zu bestimmen, sind die einzelnen Bits b, b = 0,1,...,W-1, beginnend beim MSB bzw. V ZB bis hin zum LSB nacheinander bzgl. betragsmäßig absteigender Bitwertigkeit wie folgt abzuarbeiten. Zuerst ist beim betrachteten Bit b über alle K Zahlen gesehen entweder das R-größte oder R-kleinste Bit zu bestimmen - das R-größte Bit, falls die Wertigkeit des betrachteten Bits positiv ist oder es sich beim betrachteten Bit um ein VZB mit Wert 1 für positive und Wert 0 für negative Zahlen handelt, das R-kleinste Bit in den entgegengesetzten Fällen; bei Zahlendarstellungen mit VZB ist in die Wertigkeit der dem VZB nachfolgenden Bits das dann bekannte Vorzeichen der R-größten Zahl einzurechnen. Der so bestimmte Bitwert (0 oder 1) stellt das Bit b der R-größten Zahl dar. Für die Zahlen, welche bzgl. des Bits b unterschiedlich zur R-größten Zahl sind, ist für alle nachfolgenden Bits b+1...W-1 immer der mit diesen Bits darstellbare minimale oder maximale Wert zu verwenden, abhängig davon, ob bzgl. der durch die Bits b...W-1 dargestellten Werte diese Zahlen nicht über oder unter der R-größten Zahl liegen; bei Zahlendarstellungen mit VZB ist für die durch die Bits a...W-1 dargestellten Werte im Falle a> 0 das Vorzeichen der R-größten Zahl in die Bitwertigkeiten einzurechnen."

Dieser neue Algorithmus zur allgemeinen Rangbildung lässt sich wiederum in eine sehr einfach realisierbare Filterstruktur umsetzen. Für den Fall eines eindimensionalen Filters ohne Dezimation ergeben sich im Vergleich zu der in den Fig.9a+10a, 9b+10b, 9c+10c dargestellten Medianfilterstruktur nur folgende Unterschiede:

Statt dem Median von K Bits ist das R-größte oder R-kleinste von K Bits zu bestimmen. Es gibt zusätzlich einen Block, welcher ermittelt, ob das R-größte oder das R-kleinste Bit zu bestimmen ist, also welcher Spezialfall vorliegt. Hierzu sei auf die Verfahrensschritte in den Ansprüchen verwiesen, welche die Bedingungen und Anpassung der Schritte jeweils beschreiben.

Die Blöcke "zu verwendender Bitwert" sind entsprechend zu modifizieren. Das Ausgangssignal des Filters ist dann der jeweilige R-größte Wert.

Die Bestimmung des R-größten oder R-kleinsten Bits kann wieder mit Hilfe einer Summenbildung der K Bitwerte realisiert werden. Ist das R-größte Bit gesucht, so ist für eine Bitsumme >= R das R-größte Bit gleich 1, ansonsten gleich 0; ist das R-kleinste Bit gesucht, so ist für eine Bitsumme >= K+1-R das R-kleinste Bit gleich 1, ansonsten gleich 0.

Für digitale Signale im Zeit- oder Frequenzbereich, welche nur bei einzelnen diskreten Werten einen Nutzpegel über dem Rauschpegel aufweisen, ist typischerweise eine sogenannte Rauschschwelle zu bestimmen, über welcher der Signalpegel als Nutzpegel interpretiert und weiter verwendet wird; die Rauschschwelle wird deshalb häufig auch als Detektionsschwelle bezeichnet. Zur Bestimmung der Rauschschwelle kann ein Rangfilter benutzt und in bevorzugter Weise mittels des voranstehend beschriebenen Rangfilterverfahrens bestimmt werden. Im Beispiel eines Puls-Doppler-Radars kann die Bestimmung der spektralen Detektionsschwellen z. B. durch den 99-kleinsten Wert im Leistungsspektrum der Länge 128 gebildet werden.

Nachfolgend soll die Erfindung in ihrer Verwendung in einem Radarsystem insbesondere für ein Personenkraftfahrzeug vorgestellt werden.

Moderne Kraftfahrzeuge sind zunehmend mit einem auf Radar basierenden Abstandsregelsystem ausgestattet, bei dem der Abstand, die Geschwindigkeit und der relative Winkel des vorausfahrenden Kraftfahrtzeuges ermittelt wird.

Ein solches bekanntes Radarsystem ist beispielsweise das von der Firma Bosch entwickelte FMCW-System (Frequency Modulated Continuous Wave), bei dem zwei physikalische Größen, die Entfernung und die Relativgeschwindigkeit eines bewegten oder stehenden Körpers, auf eine physikalische Größe, die Frequenz, abgebildet werden. Zu diesem Zweck werden permanent Signale ausgesendet und die von dem bewegten Körper reflektierten Signale empfangen. Aus dem Frequenzverlauf von gesendetem und empfangenem Signal bzw. aus der Frequenzdifferenz dieser Signale lässt sich auf die gesuchten Größen schließen. Eine Separierung von Geschwindigkeit und Entfernung ist durch Auswertung mehrerer Signale, sogenannte Chirps, mit unterschiedlicher Frequenzsteigung möglich. Für ein einziges Ziel würden zwei Chirps genügen, für Mehrzielsituationen sind wenigstens drei Chirps notwendig.

Zum Betreiben eines solchen Radarsystems ist insbesondere ein Oszillator (VCO) mit geringem Phasenrauschen erforderlich, der möglichst lineare Frequenzrampen bereitstellt, was nicht ohne weiteres möglich ist und wodurch der RF-Teil des Radarsystems sehr aufwendig wird. Bei Verkehrssituationen mit vielen unterschiedlichen Zielen, wie dies durch Leitplanken und im Innenstadtbereich häufig der Fall ist, ergeben sich Probleme bei der Zieldetektion und -trennung, da alle Ziele in einem Antennenstrahl in jedem zugehörigen Chirp-Spektrum vorhanden sind. Eine exakte Extrahierung der unterschiedlichen Ziele ist daher nicht oder nicht immer zufriedenstellend möglich.

Um diese Probleme zu umgehen, bietet sich das Puls-Doppler-Verfahren an. Bei diesem Verfahren wird ein Ziel jeweils auf ein oder mehrere aufeinanderfolgende Entfemungstore abbildet. Das empfangene Signal wird dabei geeignet abgetastet. Aus dem Amplitudenverhältnis der Abtastwerte in aufeinanderfolgenden Entfemungstoren kann dann auf die genaue Entfernung geschlossen werden.

Allerdings besitzt der Puls-Doppler-System aufgrund der reduzierten mittleren Ausgangsleistung ein geringes Signal-Rausch-Verhältnis (S/N). Aufgrund des breitbandigen Empfangspfads weist dieses Radarsystem auch eine höhere Störbarkeit auf.

Bei dem Puls-Doppler-Verfahren wird, um das Vorzeichen der Geschwindigkeit zu erkennen, eine komplexe Abtastung des empfangenen Signals vorgenommen. Radarsystem nach dem Puls-Doppler-Verfahren zeichnen sich dadurch aus, dass die Geschwindigkeit und die Entfernung direkte Messgrößen darstellen. Der RF-Teil lässt sich im Vergleich zu dem eingangs genannten FMCW-System sehr viel einfacher realisieren, da hier ein freilaufender Oszillator (VCO) mit geringen Anforderungen an sein Phasen- und Amplitudenrauschen benutzt werden kann und keine Frequenzrampen erzeugt werden müssen.

Es werden bei einem solchen Radarsystem für einen Messzyklus eine Vielzahl, beispielsweise 1024, Sendeimpulse pro Empfangsantenne ausgewertet. Deren Abstand beträgt dann z.B. 2.5µs. Der Abstand ist zudem pseudo-noise-kodiert, um Überreichweiten und Interferenzen zu vermeiden.

Bei Verwendung einer hohen Anzahl an Sendeimpulsen ist eine genauere Geschwindigkeitsmessung sowie ein hoher Integrationsgewinn möglich und darüber hinaus ist das aufgrund der Pseudo-Noise-Kodierung erzeugte Rauschen gering, so dass ein optimaleres Signal-Rausch-Verhältnis erreichbar ist.

In Fig.1 a) ist für eine gepulstes System die Amplitude bzw. Einhüllende ŝ(t) der ausgesendeten Welle der Frequenz fₛ für den Fall von rechteckförmigen Impulsen dargestellt. Die Zeitpunkte, bei denen die Sendeimpulse beginnen, sind im Folgenden mit tp(n) bezeichnet, der Abstand von zwei aufeinanderfolgenden Impulsen ist die Pulswiederholzeit T_{PW}(n).

Wird diese Welle mit der Ausbreitungsgeschwindigkeit c an einem Objekt in der Entfernung a reflektiert, so empfängt das System nach der Laufzeit Δt = 2a/c die reflektierte und i. Allg. gedämpfte Welle e(t); in Fig.1 b) ist die Amplitude bzw. Einhüllende ê(t) der empfangenen Welle dargestellt. Somit kann aus der Laufzeit At auf die Entfernung des Objekts geschlossen werden, solange die Laufzeit Δt immer kleiner als die Pulswiederholzeit T_{PW}(n) ist; im anderen Fall entstehen Mehrdeutigkeitsprobleme - man spricht von Überreichweiten. Bewegt sich das von der Welle erfasste Objekt bzgl. des messenden Systems mit der Relativgeschwindigkeit v, so zeigt die vom System empfangene reflektierte Welle eine Frequenzverschiebung um die Dopplerfrequenz f_{D} = 2fₛv/c. Somit kann aus der Dopplerfrequenz f_{D} auf die Relativgeschwindigkeit v geschlossen werden.

In Fig.1c) ist die Amplitude bzw. Einhüllende ê(t) der empfangenen Welle beispielhaft für Überreichweiten oder Interferenzen von einem anderen gepulsten, im selben Frequenzbereich arbeitenden System dargestellt.

Ausgangspunkt zur Unterdrückung von Überreichweiten und Interferenzen ist eine Pseudo-Noise-Kodierung der Pulswiederholzeit T_{PW}(n), d.h. die Pulswiederholzeit ist nicht konstant, sondern wird einem Zufallsprozess nach variabel gestaltet. Empfangene Impulse, welche von Überreichweiten oder einem anderen gepulsten System stammen, haben dann zum unmittelbar zuvor ausgesendeten Impuls nicht immer den gleichen, sondern einen stochastisch verteilten Abstand.

Das empfangene Signal e(t) wird vorzugsweise nach entsprechender Aufbereitung (z. B. Abmischung auf eine Zwischenfrequenz oder ins Basisband, IQ-Bildung, Filterung) abgetastet. Dabei sind die Abtastzeitpunkte so gewählt, dass sie zur vorhergehenden Sendeimpulszeit t_{P}(n) einen zeitlichen Abstand t_{A}(m), m ∈ {0,1,...,M-1} besitzen; jeder zeitliche Abstand t_{A}(m), m = 0,1,...,M-1, entspricht einem sogenannten Entfemungstor. Für jedes der M Entfemungstore werden pro Zyklus insgesamt N(m) Abtastwerte gebildet; in welcher Weise dies geschieht, ob z. B. seriell oder parallel, ist für die weitere Betrachtung nicht relevant.

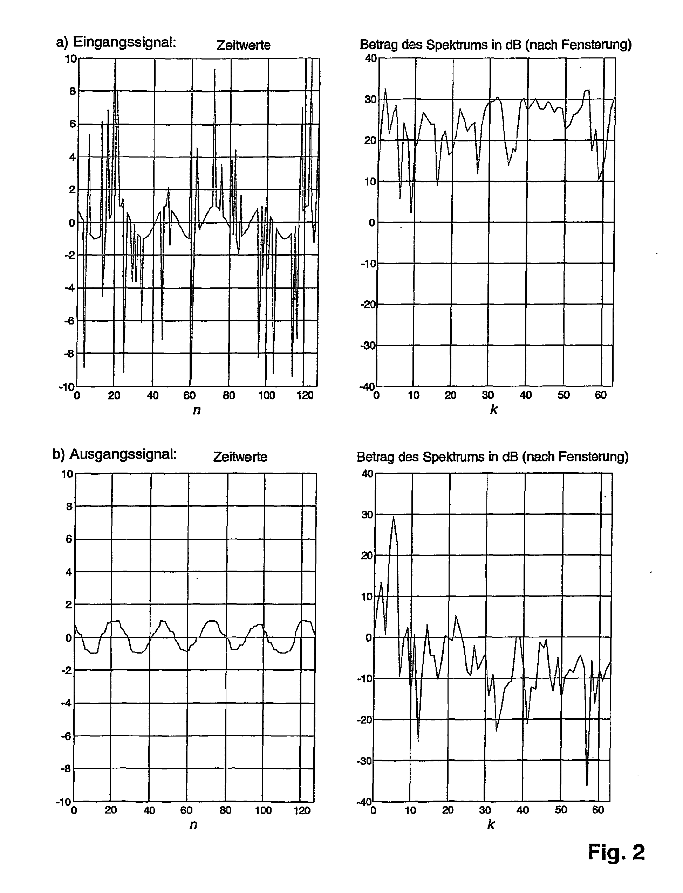

Bei Überreichweiten und Interferenzen durch gepulste, im selben Frequenzbereich arbeitende Systeme sind wegen der Pseudo-Noise-Kodierung der Pulswiederholzeit T_{PW}(n) in jedem Entfemungstor i. Allg. nur einzelne Abtastwerte gestört - man spricht von transienten Störem. Aber dies könnte im Falle hoher Störungen schon reichen, dass die weitere Signalverarbeitung (Spektralanalyse zur Dopplerbestimmung z. B. durch FFT oder Leistungsanalyse z. B. durch Leistungsintegration) unbrauchbare Ergebnisse liefert. Fig. 2a zeigt als Beispiel im diskreten Zeitbereich eine Sinusschwingung, welcher zahlreiche hohe Störimpulse überlagert sind; im Spektrum des resultierenden Signals ist der spektrale Peak der Sinusschwingung in dem von den Störimpulsen erzeugten Rauschen verschwunden.

Hier kommt nun die Medianfilterung zum Einsatz. Die Medianfilterlängen sind vorzugsweise umso höher zu wählen, je mehr Werte gestört sein können; bei einer Leistungsanalyse kann man die Medianfilterlängen bis hin zur Zahl N(m) an Abtastwerten wählen, im Falle einer Spektralanalyse zur Dopplerbestimmung werden die Medianfilterlängen durch die größte zu detektierende Dopplerfrequenz begrenzt (wegen dem Tiefpasscharakter von Medianfiltem), was eine Überabtastung voraussetzt.

Für das in Fig. 2a dargestellte gestörte Signal ergibt sich nach einem zweistufigen Medianfilter mit jeweiliger Filterlänge K = 5 der in Fig. 2b dargestellte Verlauf; das Nutzsignal, eine Sinusschwingung, ist im Zeitbereich fast vollständig wieder rekonstruiert und im Spektrum somit deutlich sichtbar.

Kombiniert man also die Pseudo-Noise-Kodierung der Pulswiederholzeit und die Medianfilterung als eine zur Unterdrückung von transienten Störem geeignete nichtlineare Filterung, so kann man den Einfluss von Überreichweiten und Interferenzen durch gepulste, im selben Frequenzbereich arbeitende Systeme stark vermindern oder gänzlich eliminieren. Zudem ist zunächst vorzugsweise in jedem Entfemungstor eine adäquate Vorverarbeitung der Abtastwerte vorgesehen, wie z. B. eine Betragsquadratbildung für eine Leistungsanalyse.

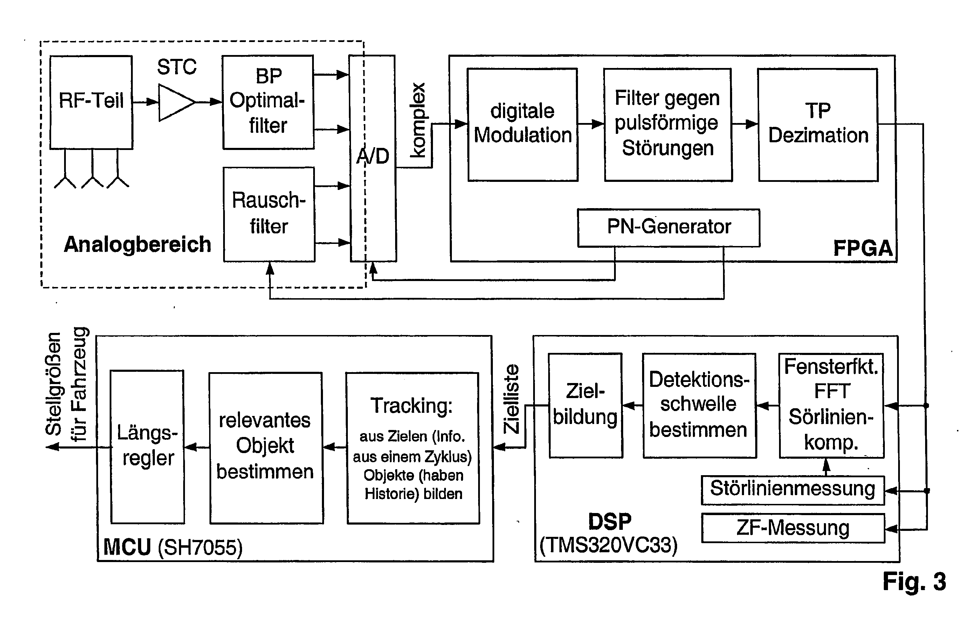

Figur 3 zeigt anhand eines Blockschaltbildes das erfindungsgemäße Puls-Doppler-Radarsystem. Die einzelnen Elemente dieses Systems, insbesondere das Optimalfilter und die Elemente des FPGAs werden anschließend noch detailliert erläutert.

Das Radarsystem weist ein RF-Empfangsteil mit nachgeschaltetem Verstärker, Bandpass-Optimalfilter und A/D-Wandler auf. Am Ausgang des A/D-Wandlers ist ein komplexes Ausgangssignal abgreifbar, welches einem nachgeschalteten FPGA zuführbar ist. Der FPGA besteht aus einer digitalen Modulationseinrichtung, dem Medianfilter gegen pulsförmige Störungen und einem als Tiefpass ausgebildeten Dezimationsfilter, die in Reihe zueinander angeordnet sind. Die FPGA-Einheit enthält außerdem einen PN-Generator. Ferner ist ein Rauschfilter vorgesehen, welches dem A/D-Wandler vorgeschaltet angeordnet ist.

Dem FPGA nachgeschaltet ist ein digitaler Signal-Prozessor (DSP), der im vorliegenden Fall eine Einrichtung zur Erzeugung einer Fensterfunktion, eine FFT-Einrichtung (Fast-Fourier-Transformation) sowie einen Störlinienkompensator aufweist. Anschließend wird ausgehend davon die Detektionsschwelle bestimmt und einer Einrichtung zur Zielbildung, die eine Zielliste erzeugt, zugeführt Dem DSP nachgeschaltet ist eine Mikrocontrollereinheit (MCU), die ausgehend von der Zielliste im Bedarfsfall Stellgrößen für das Fahrzeug erzeugt. Zu diesem Zwecke wird zunächst ein "Tracking" der Zielliste vorgenommen und ein relevantes Objekt bestimmt. Die Information darüber wird einem Längsregler zugeführt, der dann die gewünschten Stellgrößen erzeugt. Die Funktion des DSP und der MCU können selbstverständlich auch durch eine einzige programmgesteuerte Einheit, beispielsweise einen Mikrocomputer, erfüllt werden.

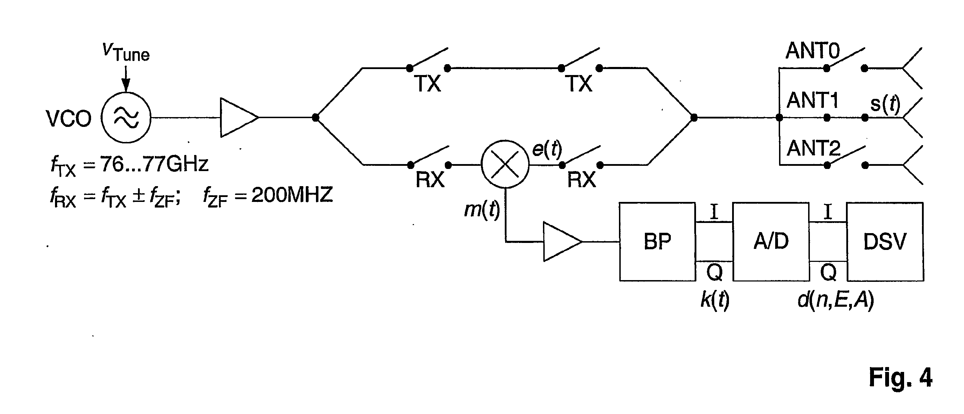

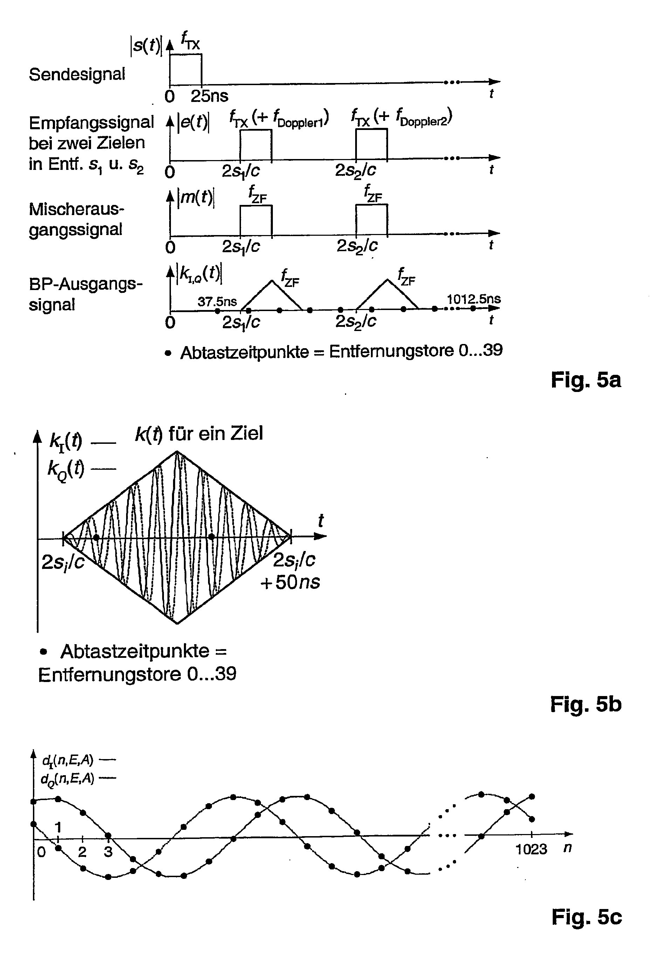

Nachfolgend soll anhand der Figuren 4 und 5 das Doppler-Verfahren kurz erläutert werden. Dabei zeigt Figur 4 anhand eines vereinfachten Schaltbildes das Prinzip des Doppler-Verfahrens und Figur 5 die Signal-Zeit-Diagramme für das Schaltbild nach Figur 4.

Bei dem Doppler-Verfahren wird eine komplexe Abtastung des empfangenen Signals vorgenommen, um das Vorzeichen der Geschwindigkeit zu erkennen. Radarsystem mit dem Puls-Doppler-Verfahren zeichnen sich dadurch aus, dass die Geschwindigkeit und die Entfernung direkte Messgrößen darstellen. Das RF-Teil lässt sich dadurch im Vergleich zu dem eingangs genannten FMCW-System sehr viel einfacher realisieren, da hier ein freilaufender Oszillator (VCO) mit geringen Anforderungen an sein Phasen- und Amplitudenrauschen verwendet werden kann und keine Frequenzrampen erzeugt werden müssen.

Ein Messzyklus dauert bspw. jeweils 50ms. Das Messergebnis ist eine Zielliste, d.h. eine Momentaufnahme der Verkehrssituation. Jedem Messzyklus sind 5 Messblöcke, nämlich ein Störlinienmessblock, ein ZF-Messblock sowie drei Antennenmessblöcke (für jede Antenne einer), zugeordnet. Jeder dieser Messblöcke dauert 2,76ms. In dieser Zeit werden beispielsweise 1024 + 64 Sendeimpulse erzeugt, wobei die ersten 64 Sendeimpulse dem Einschwingen der Filter dienen und somit nicht verwertet werden. Nach jedem Sendeimpuls wird 40 Mal im Abstand von jeweils 25ns abgetastet. Damit wird sichergestellt, dass jedes Ziel zumindest in einem Entfemungstor erfasst wird.
Über die Schalter ANT0 bis ANT2 wird eine der drei Antennen ausgewählt. Durch Schließen der Sendeschalter TX für 25ns wird das Signal des Oszillators auf die ausgewählte Antenne gegeben und abgestrahlt.
Nach diesem Aussenden eines rechteckförmigen Sendeimpulses werden die Empfangsschalter RX geschlossen, und die Frequenz des Oszillators wird um 200MHz geändert. Dadurch werden die Empfangsimpulse über den Mischer auf eine Zwischenfrequenz von 200MHz transformiert. Die Dopplerverschiebung der Frequenz kann an dieser Stelle unberücksichtigt bleiben. Das so resultierende reelle Signal m(t) wird auf einen als Optimalfilter ausgelegten passiven Bandpass gegeben, welcher zwei zueinander orthogonale Ausgänge gleicher Amplitude besitzt und somit das komplexe Signal k(t) erzeugt, d. h., es wird ein IQ-Signal ohne komplexe Mischung realisiert.
Das IQ-Signal am Ausgang des Bandpassfilters wird nach jedem Sendeimpuls 40mal in Abständen von 25ns abgetastet. Die einzelnen Abtastzeitpunkte korrespondieren zu jeweils einem Entfernungsbereich - sie stellen damit sogenannte Entfernungstore dar, welche eine Breite von 3.75m besitzen und bis zu einer Entfernung von 150m reichen. Da ein rechteckförmiger Empfangsimpuls der Länge 25ns durch das Bandpassfilter zu einem dreieckförmigen Impuls der doppelten Länge verschliffen wird und somit i. Allg. in zwei aufeinanderfolgenden Entfernungstoren sichtbar ist, kann durch Auswerten der Amplitudenverhältnisse dieser zwei Entfemungstore die genaue Entfernung interpoliert werden.

Für die Ermittlung der Relativgeschwindigkeit der Ziele bezüglich des eigenen Fahrzeugs und zur Erhöhung des Signal-Rausch-Verhältnisses werden die komplexen Empfangssignale von 1024 aufeinanderfolgenden Sendeimpulsen in jedem Entfernungstor E ausgewertet, ohne dabei die selektierte Antenne A zu ändern. Für den Fall äquidistanter Sendeimpulse zeigt Bild 4 den Real- und Imaginärteil d_{I}(n,E,A) und d_{Q}(n,E,A) der 1024 komplexen Abtastwerte d(n,E,A) eines Entfemungstors, in welchem sich ein relativ bewegtes Ziel befindet (während der kurzen Beobachtungsdauer von 2.56ms für die 1024 Abtastwert kann die Relativgeschwindigkeit stets als konstant betrachtet werden); von Abtastwert zu Abtastwert ändert sich die Phase gleichförmig, da sich die Entfernung des Ziels und somit die Phase des Empfangsimpulses gleichförmig ändern - es resultiert genau die Dopplerfrequenz inklusive ihrem Vorzeichen (weil das Signal komplex ist).

Das eben beschriebene Verfahren wird sequentiell für jede der drei Antennen angewendet. Eine der Antennen schaut genau geradeaus, während die zwei anderen leicht nach links bzw. rechts gerichtet sind, um so die Position der erfassten Ziele relativ zur eigenen Fahrspur bestimmen zu können

Das empfangene Signal enthält immer auch einen Störungsanteil, der sich als Rauschen bemerkbar macht. Die Störung weist näherungsweise die Charakteristik von weißem Rauschen auf. Um dieses Rauschen möglichst gut herauszufiltern, d. h. ein maximales Signal-Rausch-Verhältnis zu erzielen, wird ein Optimalfilter benutzt. Seine Übertragungsfunktion entspricht dem Spektrum der empfangenen Zwischenfrequenzimpulse (ZF-Impulse), d h. dem Spektrum eines mit 200MHz modulierten Rechtecks der Impulslänge 25ns. Das Optimalfilter entspricht somit einem Bandpass.

Das verwendete Optimalfilter wird vorteilhafterweise als ein in ohmsche Widerstände eingebetteter LC-Vierpol realisiert. Im betrachteten Frequenzbereich ist dies eine besonders günstige und flexible Technologie, da die hierfür benötigten Induktivitäten als SMD-Bauteile verfügbar sind. Die Filterschaltung kann dadurch sehr einfach, klein und damit auch kostengünstig aufgebaut werden.

Beim Entwurf eines solchen Optimalfilters nach dem bekannten Verfahren nach Bader sind zwei Entwurfsstrategien möglich:
1. Zunächst wird ein bedarfsgemäß angepasster Tiefpass entworfen. Anschließend wird daraus eine Transformation des Tiefpasses in einen Bandpass vorgenommen. Diese Variante eignet sich allerdings nur bedingt und auch nur für spezielle Schaltungen, da sie zu für die Realisierung der Schaltung ungeeigneten Strukturen und Bauteilewerten führt.
2. Direkter Entwurf eines Bandpassfilters: Diese Variante ist besonders vorteilhaft, wenngleich auch beim Entwurf etwas aufwendiger, da sie zu unterschiedlichen alternativen Strukturen führt, die je nach Anforderungen mehr oder weniger gut an die geforderten Verhältnisse angepasst sind. Bei diesem Verfahren wird zunächst eine Approximation der idealen Übertragungsfunktion vorgenommen.

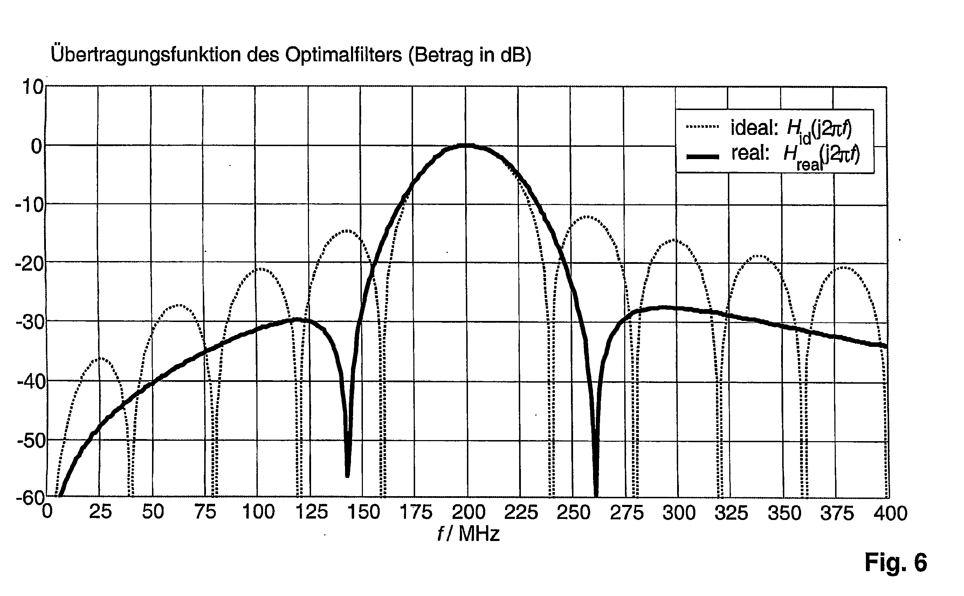

Fig. 6 zeigt gestrichelt die Übertragungsfunktion eines im direkten Entwurf hergestellten Optimalfilters; die dünne durchgehende Kurve gehört zum idealen Optimalfilter, welches durch die reale Schaltung sehr gut angenähert bzw. nachgebildet wird.

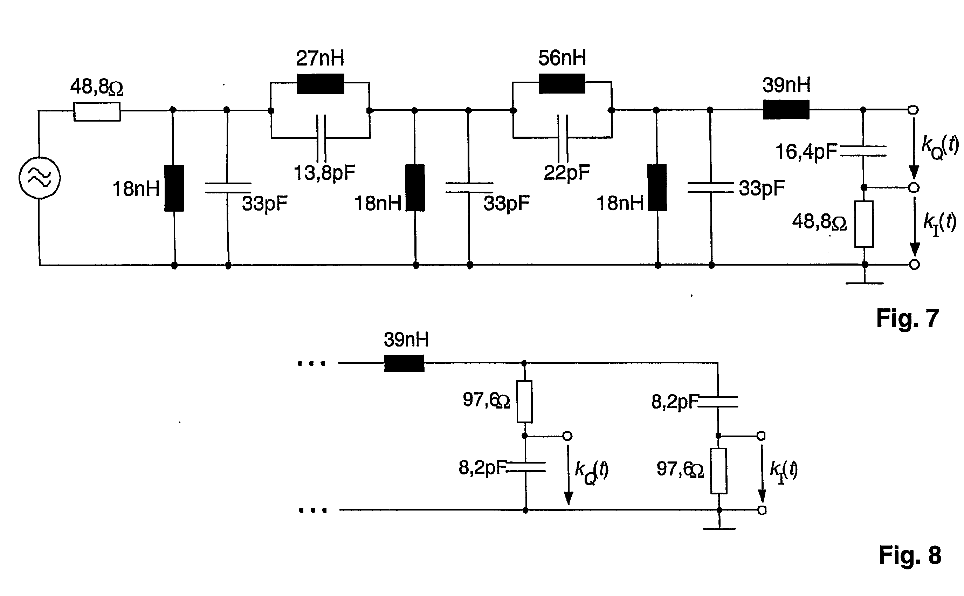

Die Figur 7 zeigt eine erste Schaltungsanordnung für die Realisierung eines nach Bader approximierten Optimalfilters: Die Werte der Induktivitäten, Kapazitäten und Widerstände sind hier auf real verfügbare Werte gerundet. Freiheitsgrade bei Entwicklung wurden hier so ausgenutzt, dass vorteilhafterweise kein Übertrager notwendig ist. Die in Figur 7 dargestellte Struktur hat im Gegensatz zu ihrer dualen Struktur von fast allen Knoten Kapazitäten gegen Masse, in welche die Streukapazitäten mit eingerechnet werden können.

Die Ausgangssignale k_{I}(t) und k_{Q}(t) der Schaltung in Figur 7 stehen orthogonal zueinander, d.h. sie weisen eine Phasendifferenz von 90° zueinander auf, und besitzen bei der Zwischenfrequenz f_{ZF}=200MHz gleiche Amplitude, was durch Freiheitsgrade bei Entwicklung erreichbar ist

Das komplexe Ausgangssignal k_{I}(t) + j*k_{Q}(t), nachfolgend IQ-Signal genannt, stellt damit eine komplexe Schwingung für die reelle Eingangsschwingung mit der Zwischenfrequenz f_{ZF} dar. Dieses sogenannte IQ-Signal wurde vorteilhafter Weise ohne jegliche Mischung realisiert.

Besonders vorteilhaft ist es, wenn sowohl der dem Realteil als auch dem Imaginärteil zugeordnete Teil des Ausgangssignals, also k_{I}(t) und k_{Q}(t), gegen Masse ausgebildet sind. Figur 6 zeigt anhand eines Schaltbildes ein zweites, bevorzugten Ausführungsbeispiels eines approximierten Optimalfilters, bei dem dieser Forderung Rechnung getragen wird. Die ausgangsseitige Teil der Filterschaltung wurde dabei im Wesentlichen aufgedoppelt.

Diese in Figur dargestellte modifizierte Ausgangsstufe hat den weiteren großen Vorteil, dass trotz ohmscher und kapazitiver Belastung durch den A/D-Wandler der I/Q-Charakter des Ausgangssignals erhalten bleibt. Lediglich die Filtercharakteristik ändert sich geringfügig.

Ein entsprechend den Figuren 7 und 8 ausgebildetes Bandpass-Optimalfilter weist zusammenfassend also die folgenden vorteilhaften Funktionen auf:
- Das Filter weist ein optimiertes Signal-Rausch-Verhältnis auf.
- Das Filter erzeugt auf einfache, jedoch sehr zuverlässige Weise ein weitestgehend exaktes IQ-Signal, welches am Ausgang des Filters abgreifbar ist.
- Da das dreieckförmige Ausgangssignal in zwei Entfemungstoren sichtbar ist und über das Amplitudenverhältnis die Entfernung bestimmt werden kann, ist auf diese Weise eine einfache Interpolation der Entfernung möglich.

Der FPGA-Block in Figur 3 weist eine Einrichtung zur digitalen Modulation des von dem Optimalfilter erzeugten komplexen Ausgangssignals auf. Eine derartige Einrichtung ist erforderlich, da der interessierende Geschwindigkeitsbereich typischerweise nicht symmetrisch ist und damit zu einem unsymmetrischen Frequenzbereich führen würde; im Anwendungsbeispiel interessieren Geschwindigkeiten im Bereich von -88,2 bis +264,7 km/h. Mittels eines Frequenzoffsets von -12.5kHz lässt sich daraus ein symmetrischer Frequenzbereich erzeugen. Mittels einer geeignet dimensionierten Einrichtung zur digitalen Modulation lässt sich dies realisieren, beispielsweise durch Multiplikation des abgetasteten IQ-Signals mit einem Signal, welches von einem umlaufenden komplexen Zeiger der Amplitude 1 und der Drehfrequenz -12.5kHz erzeugt wird.

Der FPGA-Block weist ferner ein nichtlineares Filter gegen pulsförmige Störungen auf. Pulsförmige Störungen haben ihren Ursprung z.B. in Überreichweiten oder Puls-Radar-Systemen anderer Verkehrsteilnehmer. Durch eine Pseudo-Noise-Kodierung der Abtastzeitpunkte werden pulsförmige Störungen auf alle Entfernungstore (mehr oder weniger gleichmäßig) verteilt. Dadurch sind nur einzelne Werte in jedem Entfemungstor gestört. Durch Pseudo-Noise-Kodierung und nichtlineare Filterung, beispielsweise durch Medianfilter, lassen sich unerwünschte pulsförmige Störungen kompensieren.

Für die Realisierung des Filters gegen pulsförmige Störungen ist folgende Problematik zu berücksichtigen:

Ein lineares Filter ist hier wenig vorteilhaft, da der dem Filter nachfolgende Dezimationstiefpass bereits ein lineares Filter mit minimaler Bandbreite darstellt. Denkbar sind alle nichtlinearen Filter, welche einzelne Fehlwerte kompensieren können; viele dieser Filter sind allerdings hinsichtlich der Stabilität und der Implementierung auf einem FPGA problematisch.

Hier ist vorteilhafter Weise ein ein- oder mehrstufiges Medianfilter zu verwenden. In einer bevorzugten Ausgestaltung ist dieses Filter zweistufig mit jeweils die Länge 5. Vorteilhafterweise wird durch den vorgeschalteten A/D-Wandler eine Überabtastung vorgenommen.

Der Median von K Werten ist der mittlere Wert, d.h. der (K+1)/2-kleinste Wert = (K+1)/2-größte Wert.

Zum Beispiel ist der Median der fünf Zahlen 5, 3, 2, 79, 1 gleich 3. Ein gleitendes Medianfilter ohne Reduktion der Abtastrate berechnet zu jedem Zeitpunkt n den Median von K aufeinander folgender Werte einer Eingangsfolge x(n) und erzeugt daraus ein Ausgangssignal m(n). Für Median-Filter sind viele Algorithmen bekannt, welche sich insbesondere für eine Software-Realisierung eignen. Diese basieren auf Sortierung mit einhergehender hoher Rechenzeit oder statistische Auswertung mit einhergehendem hohen Speicherbedarf von Daten. Für eine Hardware-Realisierung sind diese Algorithmen wenig geeignet, da sie typischerweise zu viele Fallunterscheidungen und Verzweigungen benötigen.

Es wurde jedoch nun ein neuer Algorithmus für eine Hardware-Realisierung eines Median-Filters entwickelt Die Funktionsweise ist bereits anhand der Figuren 9a,9b,9c und 10a,10b,10c dargestellt worden. Mit einer solchen Struktur kann in vielen Fällen der Aufwand eines Median-Filters deutlich reduziert werden, insbesondere wenn die maximale Taktzeit des FPGAs wesentlich größer als der Worttakt des Eingangssignals ist. Ein weiterer Vorteil besteht in der einfachen Skalierbarkeit der Struktur.

Der FPGA-Block in Figur 3 weist ferner ein Dezimationsfilter auf. Das Dezimationsfilter ist vorteilhafterweise als Tiefpass ausgebildet.

Im vorliegenden Ausführungsbeispiel wird eine Dezimation der Abtastfrequenz von 400kHz auf 50kHz, also um den Faktor 8, vorgenommen. Dadurch ist - im Falle eines idealen Dezimationstiefpasses - eine Verbesserung des Signal-Rausch-Verhältnisses um 9dB möglich.

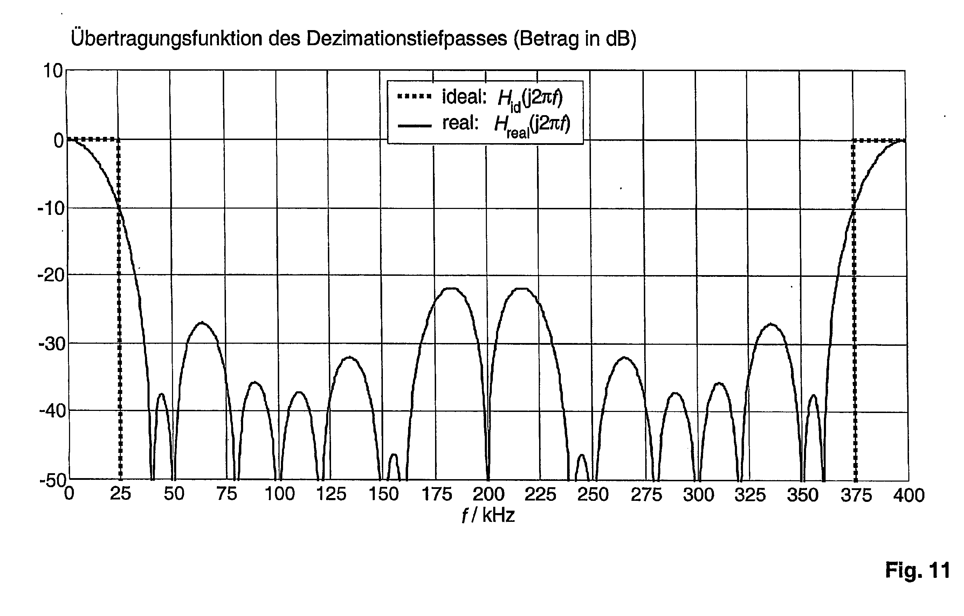

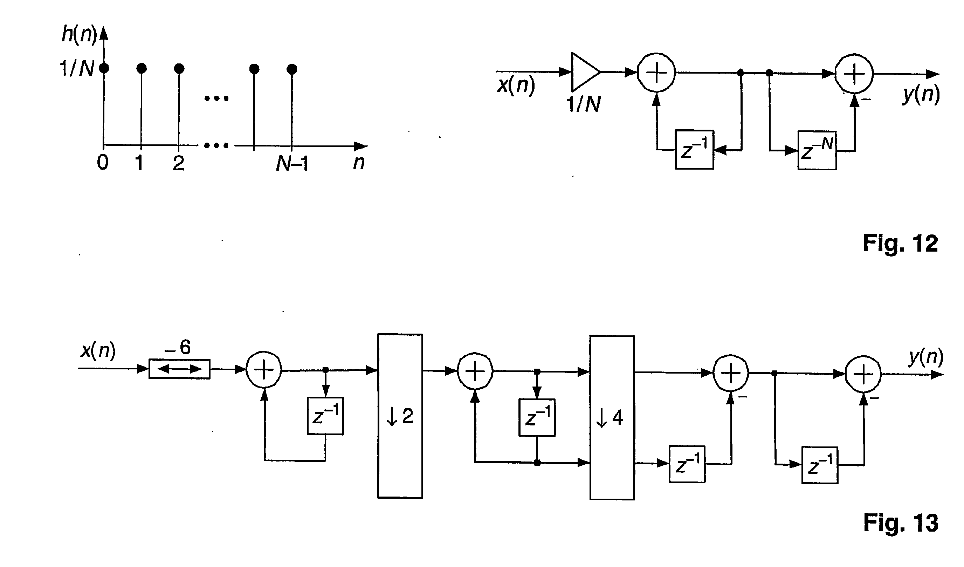

Ein realer Dezimationstiefpass muss die Anforderung möglichst steiler Flanken um die Frequenzen f = ±25kHz herum erfüllen. Nicht erforderlich ist |Hᵣₑₐₗ(j2πf)| ≈ const im Durchlassbereich |f| < 25kHz, da bei der Auswertung lediglich Spektren verwertet werden und dabei auf einfache Weise Amplitudenfehler kompensiert werden können. In der Figur 11 ist die Übertragungsfunktion eines idealen und eines realen Dezimationstiefpasses dargestellt. Der dafür verwendete Tiefpass besteht aus zwei gleitenden Mittelwertbildnern, wobei der zweite schon mit der halbierten Eingangstaktrate arbeitet. Der gleitende Mittelwertbildner der Länge N mittelt über den aktuellen und die N-1 vorhergehenden Werte. Figur 12 zeigt die Impulsantwort h(n) eines solchen gleitenden Mittelwertbildners sowie ein Signalflussdiagramm. Der Mittelwertbildner lässt sich sehr effizient in rekursiver Form realisieren.

Die Gesamtstruktur eines vorteilhaften Ausführungsbeispiels eines Dezimationstiefpasses ist in Figur 13 dargestellt. Ein fehlender Faktor 64/40 am Ausgang wird bei einer späterer Fensterung für die digitale Fourier-Transformation (DFT) mit realisiert. Für ein solches Dezimationsfilter mit dem Grad 15 müssen also folgende Elemente bereitgestellt werden: ein Shifter, vier Addierer, vier Speicherelemente. Ein Multiplizierer ist aber nicht erforderlich. Im Vergleich dazu müssen bei einem üblichen linearphasigen Filter mit dem Grad 15 insgesamt acht Multiplizierer, 15 Addierer, 15 Speicher bereitgestellt werden. Das Dezimationsfilter zeichnet sich also auch durch einen deutlich geringeren schaltungstechnischen Aufwand aus.

## Patentansprüche

1. Verfahren zur digitalen Filterung von K Eingangswerten mittels eines nichtlinearen Filters, wobei das Filter als Ausgangswert den R-größten Wert aus den K Eingangswerten erzeugt, wobei K ≥ R ≥ 1, und wobei die Eingangswerte in binärer Einer- oder Zweierkomplementdarstellung in Festkommaformat vorliegen, bei weicher der Betrag der Bitwertigkeiten von einem höchstsignifikanten Bit MSB zu einem niedersignifikantesten Bit LSB hin jeweils mit dem Faktor 1/2 abnimmt und nur die Bitwerte 0 und 1 vorkommen, in dem:
a) für die einzelnen Bits der Eingangs- und Ausgangswerte in betragsmäßig absteigender Bitwertigkeit beginnend mit dem höchstsignifikanten Bit MSB nacheinander bis zum niedersignifikantesten Bit LSB
b) beim jeweils aktuell betrachteten Bit,
- falls es das höchstsignifikante Bit MSB ist, über alle K Eingangswerte gesehen der R-kleinste Bitwert bestimmt wird, welcher 0 ist, falls beim aktuell betrachteten Bit über alle K Eingangswerte gesehen nicht weniger als R-mal der Bitwert 0 auftritt, ansonsten ist der R-kleinste Bitwert gleich 1,
- falls es nicht das höchstsignifikante Bit MSB ist, über alle K Eingangswerte gesehen der R-größte Bitwert bestimmt wird, welcher 1 ist, falls beim aktuell betrachteten Bit über alle K Eingangswerte gesehen nicht weniger als R-mal der Bitwert 1 auftritt, ansonsten ist der R-größte Bitwert gleich 0,
c) wobei der so bestimmte Bitwert dann den Bitwert für das aktuell betrachtete Bit des R-größten Wertes und damit des Ausgangswertes darstellt,
d) und für diejenigen Eingangswerte, bei welchen der Bitwert des aktuell betrachteten Bits nicht dem so bestimmten Bitwert entspricht, als Bitwerte aller nachfolgenden Bits:
- der invertierte Bitwert dieser Eingangswerte am aktuell betrachteten Bit verwendet wird, sofern das aktuell betrachtete Bit das höchstsignifikante Bit MSB ist,
- der Bitwert dieser Eingangswerte am aktuell betrachteten Bit verwendet wird, sofern das aktuell betrachtete Bit nicht das höchstsignifikante Bit MSB ist.

2. Verfahren zur digitalen Filterung nach Anspruch 1, wobei als Ausgangswert der Median einer ungeraden Anzahl K von Eingangswerten in binärer Einer- oder Zweierkomplementdarstellung erzeugt wird, bei dem somit R=(K+1)/2 ist und in dem:
im Schritt b) jeweils geprüft wird, ob über alle K Eingangswerte gesehen beim aktuell betrachteten Bit als Bitwert mehr Einsen oder Nullen auftreten, und
im Schritt c) der häufiger auftretende Bitwert dann den Bitwert für das aktuell betrachtete Bit des Median und damit des Ausgangswertes darstellt.

3. Verfahren zur digitalen Filterung von K Eingangswerten mittels eines nichtlinearen Filters, wobei das Filter als Ausgangswert den R-größten Wert aus den K Eingangswerten erzeugt, wobei K ≥ R ≥ 1, und wobei die Eingangswerte in binärer Vorzeichen-Betrag-Darstellung in Festkommaformat vorliegen, bei welcher der Betrag der Bitwertigkeiten von einem höchstsignifikanten Bit MSB zu einem niedersignifikantesten Bit LSB hin jeweils mit dem Faktor 1/2 abnimmt und nur die Bitwerte 0 und 1 vorkommen, in dem:
a) für die einzelnen Bits der Eingangs- und Ausgangswerte beginnend mit dem Vorzeichenbit VZB, gefolgt von dem höchstsignifikanten Bit MSB nacheinander bzgl. betragsmäßig absteigender Bitwertigkeit bis zum niedersignifikantesten Bit LSB
b) beim jeweils aktuell betrachteten Bit,
- falls es das Vorzeichenbit VZB ist oder falls die Wertigkeit des aktuell betrachteten Bits negativ ist, über alle K Eingangswerte gesehen der R-kleinste Bitwert bestimmt wird, welcher 0 ist, falls beim aktuell betrachteten Bit über alle K Eingangswerte gesehen nicht weniger als R-mal der Bitwert 0 auftritt, ansonsten ist der R-kleinste Bitwert gleich 1,
- falls es nicht das Vorzeichenbit VZB oder falls die Wertigkeit des aktuell betrachteten Bits positiv ist ist, über alle K Eingangswerte gesehen der R-größte Bitwert bestimmt wird, welcher 1 ist, falls beim aktuell betrachteten Bit über alle K Eingangswerte gesehen nicht weniger als R-mal der Bitwert 1 auftritt, ansonsten ist der R-größte Bitwert gleich 0,
c) wobei der so bestimmte Bitwert dann den Bitwert für das aktuell betrachtete Bit des R-größten Wertes und damit des Ausgangswertes darstellt,
d) und für diejenigen Eingangswerte, bei welchen der Bitwert des aktuell betrachteten Bits nicht dem so bestimmten Bitwert entspricht, als Bitwerte aller bezüglich der Reihenfolge nach a) nachfolgenden Bits
- der Bitwert 0 verwendet wird, sofern das aktuell betrachtete Bit das Vorzeichenbit VZB ist,
- der Bitwert dieser Eingangswerte am aktuell betrachteten Bit verwendet wird, sofern das aktuell betrachtete Bit nicht das Vorzeichenbit VZB ist.

4. Verfahren zur digitalen Filterung nach Anspruch 3, wobei als Ausgangswert der Median einer ungeraden Anzahl K von Eingangswerten in binärer Vorzeichen-Betrag-Darstellung erzeugt wird, bei dem somit R=(K+1)/2 ist und in dem:
im Schritt b) jeweils geprüft wird, ob über alle K Eingangswerte gesehen beim aktuell betrachteten Bit als Bitwert mehr Einsen oder Nullen auftreten, und
im Schritt c) der häufiger auftretende Bitwert dann den Bitwert für das aktuell betrachtete Bit des Median und damit des Ausgangswertes darstellt.

5. Verfahren nach einem der vorangehenden Ansprüche, wobei zur Durchführung von Schritt d) für die Eingangswerte, bei welchen der Bitwert des aktuell betrachteten Bits nicht dem in c) bestimmten Bitwert des Ausgangswertes entspricht, alle nachfolgenden Bits im Speicher entsprechend ersetzt und für nachfolgende Schritte b) auf die entsprechend ersetzten Bitwerte zugegriffen wird.

6. Verfahren nach einem der vorangehenden Ansprüche, wobei ein Register vorgesehen ist, in welchem für jeden Eingangswert abgelegt ist,
- ob für den jeweiligen Eingangswert bereits bei einem vorhergehend betrachteten Bit der Bitwert dieses Eingangswertes nicht dem in c) bestimmten Bitwert des Ausgangswertes entsprochen hat und
- falls ja, welcher Bitwert dann aktuell für diesen Eingangswert in Schritt b) zu verwenden ist.

7. Verfahren nach einem der Ansprüche 1-6, wobei in Schritt b) die Bestimmung der Anzahl des Auftretens vom Bitwert 1 bzw. 0 beim aktuell betrachteten Bit über die K Eingangswerte erfolgt, indem die Bitwerte binär addiert werden, und der Additionswert somit der Anzahl des Auftretens des Wertes 1 bzw. K minus dem Additionswert der Anzahl des Auftretens des Wertes 0 entspricht.

8. Verfahren nach einem der Ansprüche 1-7, welches abbricht, wenn es in Schritt d) nur noch einen Eingangswert gibt, dessen Bitwerte bei allen bisher betrachteten Bits inklusive dem aktuell betrachteten Bit jeweils dem in c) bestimmten Bitwert des Ausgangswertes entsprochen haben, wobei die restlichen Bits des Ausgangswertes dann denen dieses Eingangswertes entsprechen.

9. Digitales Filter umfassend eine Recheneinheit, auf der ein Verfahren nach einem der vorherigen Ansprüche hinterlegt ist, welches sukzessive aus K benachbarten digitalen Werten eines beliebig langen ein- oder mehrdimensionalen Eingangssignals einen digitalen Wert des Ausgangssignals nach einem der vorangehenden Verfahren ermittelt, wobei die Datenrate am Eingang des Filters und die Datenrate am Ausgang identisch sind.

10. Digitales Filter umfassend eine Recheneinheit, auf der ein Verfahren nach einem der Anprüche 1-8 hinterlegt ist, welches sukzessive aus K benachbarten digitalen Werten eines beliebig langen ein- oder mehrdimensionalen Eingangssignals einen digitalen Wert des Ausgangssignals nach einem der vorangehenden Verfahren ermittelt, wobei die Datenrate am Eingang des Filters größer als die Datenrate am Ausgang ist.

11. Digitales Filter umfassend eine Recheneinheit, auf der ein Verfahren nach einem der Ansprüche 1-8 hinterlegt ist, welches sukzessive aus K benachbarten digitalen Werten eines beliebig langen ein- oder mehrdimensionalen Eingangssignals einen digitalen Wert des Ausgangssignals nach einem der vorangehenden Verfahren ermittelt, wobei die Datenrate am Eingang des Filters um den Faktor K größer als die Datenrate am Ausgang ist, d. h., jeder Wert des Einganssignals wird nur einmal benutzt.

12. Signalverarbeitungssystem mit einer Abtastvorrichtung zur Abtastung eines Eingangssignals, einem Analog-Digital-Wandler zur Digitalisierung des abgetasteten Eingangssignals und einem digitalen Filter nach einem der Ansprüche 9 bis 11.

13. Verwendung eines Signalverarbeitungssystems nach Anspruch 12 zur Unterdrückung transienter Störungen in einem Eingangssignal durch ein Medianfilterverfahren nach einem der Ansprüche 2, 4 oder 5-8 in Verbindung mit Anspruch 2 oder 4.

14. Verwendung eines Verfahrens nach einem der Ansprüche 1-8, um für digitale Signale im Zeit-oder Frequenzbereich, welche nur bei einzelnen diskreten Werten einen Nutzpegel über dem Rauschpegel aufweisen, eine Rauschschwelle zu bestimmen, über welcher der Signalpegel als Nutzpegel interpretiert und weiter verwendet wird.

15. Optisches System zur Objekterfassung, bei dem Lichtimpulse, vorzugsweise im Infrarot-Wellenlängenbereich ausgesendet werden, mit einem Signalverarbeitungssystem nach Anspruch 12.

16. Radarsystem zur Objekterfassung mit einem Signalverarbeitungssystem nach Anspruch 12.

17. Ultraschallsystem zur Objekterfassung mit einem Signalverarbeitungssystem nach Anspruch 12.

## Claims

1. A method for digital filtering of K input values by means of a non-linear filter, wherein the filter produces the R^{th} largest value from the K input values as an output value, wherein K ≥ R ≥ 1, and wherein the input values are provided in fixed-point, binary one's complement representation or two's complement representation, where the bit significance decreases from a most significant bit MSB towards a least significant bit LSB by the factor of 1/2 in each case and the bit values are either 0 or 1, in which method:
a) for the individual bits of the input and output values, in accordance with the decrease in bit significance, starting with the most significant bit MSB and successively down to the least significant bit LSB,
b) for the currently examined bit in each case,
- if it is the most significant bit MSB, the R^{th} smallest bit value is determined taking into account all K input values, which bit value is 0 if the bit value of 0 occurs at least R times in the currently examined bit, taking into account all K input values; otherwise, the R^{th} smallest bit value is 1,
- if it is not the most significant bit MSB, the R^{th} largest bit value is determined taking into account all K input values, which bit value is 1 if the bit value of 1 occurs at least R times in the currently examined bit, taking into account all K input values; otherwise, the R^{th} largest bit value is 0,
c) wherein the bit value determined in this way then constitutes the bit value for the currently examined bit of the R^{th} largest value and hence of the output value,
d) and for those input values where the bit value of the currently examined bit is not the same as the bit value determined in this way, the following applies to the bit values of all subsequent bits:
- the inverted bit value of these input values is used for the currently examined bit if the currently examined bit is the most significant bit MSB,
- the bit value of these input values is used for the currently examined bit if the currently examined bit is not the most significant bit MSB.

2. A digital filtering method according to claim 1, wherein the median of an odd number K of input values provided in binary one's complement representation or two's complement representation is produced as an output value, where in consequence R = (K+1)/2, and in which method:
in step b), it is checked in each case whether the currently examined bit has more ones or zeros as bit value, taking into account all K input values, and
in step c), the more frequent bit value constitutes the bit value for the currently examined bit of the median and hence of the output value.

3. A method for digital filtering of K input values by means of a non-linear filter, wherein the filter produces the R^{th} largest value from the K input values as an output value, wherein K ≥ R ≥ 1, and wherein the input values are provided in fixed-point, binary sign-value representation, where the bit significance decreases from a most significant bit MSB towards a least significant bit LSB by the factor of 1/2 in each case and the bit values are either 0 or 1, in which method:
a) for the individual bits of the input and output values, starting with the sign bit VZB, followed by the most significant bit MSB and successively down to the least significant bit LSB in accordance with the decrease in bit significance,
b) for the currently examined bit in each case,
- if it is the sign bit VZB or if the significance of the currently examined bit is negative, the R^{th} smallest bit value is determined taking into account all K input values, which bit value is 0 if the bit value of 0 occurs at least R times in the currently examined bit, taking into account all K input values; otherwise, the R^{th} smallest bit value is 1,
- if it is not the sign bit VZB or if the significance of the currently examined bit is positive, the R^{th} largest bit value is determined taking into account all K input values, which bit value is 1 if the bit value of 1 occurs at least R times in the currently examined bit, taking into account all K input values; otherwise, the R^{th} largest bit value is 0,
c) wherein the bit value determined in this way then constitutes the bit value for the currently examined bit of the R^{th} largest value and hence of the output value,
d) and for those input values where the bit value of the currently examined bit is not the same as the bit value determined in this way, the following applies to the bit values of all bits following a) in order of occurrence:
- the bit value of 0 is used if the currently examined bit is the sign bit VZB,
- the bit value of these input values is used for the currently examined bit if the currently examined bit is not the sign bit VZB.

4. A digital filtering method according to claim 3, wherein the median of an odd number K of input values provided in binary sign-value representation is produced as an output value, where in consequence R = (K+1)/2, and in which method:
in step b), it is checked in each case whether the currently examined bit has more ones or zeros as bit value, taking into account all K input values, and
in step c), the more frequent bit value constitutes the bit value for the currently examined bit of the median and hence of the output value.

5. A method according to any one of the preceding claims, wherein, to carry out step d) for the input values where the bit value of the currently examined bit is not the same as the bit value of the output value determined in c), all subsequent bits are replaced in memory accordingly, and said replaced bit values are retrieved for subsequent steps b).

6. A method according to any one of the preceding claims, wherein a register is provided in which the following information is stored for each input value:
- whether for the input value in question, the bit value of this input value was already not the same as the bit value of the output value determined in c) in a bit examined earlier, and
- if so, which bit value is to be used at present for this input value in step b).

7. A method according to any one of claims 1-6, wherein in step b), the frequency of the bit value of 1 or 0 in the currently examined bit, taking into account the K input values, is determined by binary adding the bit values, and the sum is therefore equal to the frequency of the value of 1 and K minus the sum is equal to the frequency of the value of 0.

8. A method according to any one of claims 1-7, which is stopped when in step d), there is only one input value left whose bit values, taking into account all bits that have been examined so far and including the currently examined bit, have each been the same as the bit value of the output value determined in c), wherein the remaining bits of the output value are then the same as those of this input value.

9. A digital filter comprising a computing unit where a method according to any one of the preceding claims is stored, which filter successively determines from K adjacent digital values of a one- or multidimensional input signal of any desired length a digital value of the output signal according to any one of the preceding methods, wherein the data rate at the input of the filter and the data rate at the output are identical.

10. A digital filter comprising a computing unit where a method according to any one of claims 1-8 is stored, which filter successively determines from K adjacent digital values of a one- or multidimensional input signal of any desired length a digital value of the output signal according to any one of the preceding methods, wherein the data rate at the input of the filter exceeds the data rate at the output.

11. A digital filter comprising a computing unit where a method according to any one of claims 1-8 is stored, which filter successively determines from K adjacent digital values of a one- or multidimensional input signal of any desired length a digital value of the output signal according to any one of the preceding methods, wherein the data rate at the input of the filter exceeds the data rate at the output by the factor of K, i.e. each value of the input signal is used only once.

12. A signal processing system comprising a scanning device for scanning an input signal, an analogue to digital converter for digitizing the scanned input signal, and a digital filter according to any one of claims 9 to 11.

13. The use of a signal processing system according to claim 12 to suppress transient interference in an input signal by means of a median filtering method according to any one of claims 2, 4 or 5-8 in conjunction with claim 2 or 4.

14. The use of a method according to any one of claims 1-8 to determine, for digital signals in the time or frequency range whose useful level only exceeds the noise level in individual discrete values, a noise threshold above which the signal level is considered to be a useful level and continued to be used.

15. An optical system for the detection of objects, in which light pulses, preferably in the infrared wavelength range, are emitted, comprising a signal processing system according to claim 12.

16. A radar system for the detection of objects, comprising a signal processing system according to claim 12.

17. An ultrasonic system for the detection of objects, comprising a signal processing system according to claim 12.

## Revendications

1. Procédé de filtrage numérique de K valeurs d'entrée au moyen d'un filtre non linéaire, le filtre produisant en tant que valeur de sortie la R^{ième} plus grande valeur à partir des K valeurs d'entrée, où K ≥ R ≥ 1, et les valeurs d'entrée se présentant dans le format en virgule fixe dans une représentation binaire de complément à un ou à deux, dans laquelle le montant des poids du bit diminue respectivement selon le facteur ½ depuis un bit de poids fort MSB vers un bit de poids faible LSB, et dans laquelle n'apparaissent que les valeurs binaires 0 et 1, dans lequel :
a) pour les différents bits des valeurs d'entrée et de sortie, dans un poids du bit dont le montant diminue en commençant par le poids du bit diminuant de montant avec le bit de poids fort MSB successivement jusqu'au bit de poids faible LSB,
b) pour le bit considéré actuellement respectivement,
- si c'est le bit de poids fort MSB, la R^{ième} plus petite valeur binaire vue sur toutes les K valeurs d'entrée est déterminée, qui est 0, si, pour le bit considéré actuellement vu sur toutes les K valeurs d'entrée, la valeur binaire 0 apparaît pas moins de R fois, sinon la R^{ième} plus petite valeur binaire est égale à 1,
- si ce n'est pas le bit de poids fort MSB, la R^{ième} plus grande valeur binaire vue sur toutes les K valeurs d'entrée est déterminée, qui est 1, si, pour le bit considéré actuellement vu sur toutes les K valeurs d'entrée, la valeur binaire 1 apparaît pas moins de R fois, sinon la R^{ième} plus grande valeur binaire est égale à 0,
c) la valeur binaire ainsi déterminée représentant ensuite la valeur binaire pour le bit considéré actuellement de la R^{ième} plus grande valeur et ainsi de la valeur de sortie,
d) et pour les valeurs d'entrée pour lesquelles la valeur binaire du bit considéré actuellement ne correspond pas à la valeur binaire ainsi déterminée, en tant que valeurs binaires de tous les bits suivants :
- la valeur binaire inversée de ces valeurs d'entrée est utilisée sur le bit considéré actuellement dans la mesure où le bit considéré actuellement est le bit de poids fort MSB,
- la valeur binaire de ces valeurs d'entrée est utilisée sur le bit considéré actuellement dans la mesure où le bit considéré actuellement n'est pas le bit de poids fort MSB.

2. Procédé de filtrage numérique selon la revendication 1, la médiane d'un nombre impair K de valeurs d'entrée étant produite en tant que valeur de sortie dans une représentation binaire de complément à un ou à deux, dans lequel ainsi R=(K+1)/2 et dans lequel :
dans l'étape b), il est contrôlé respectivement si, vu sur toutes les K valeurs d'entrée pour le bit considéré actuellement, il apparaît, en tant que valeur binaire, davantage de uns ou de zéros, et
dans l'étape c), la valeur binaire apparaissant plus souvent représente ensuite la valeur binaire pour le bit de la médiane considéré actuellement et donc de la valeur de sortie.

3. Procédé de filtrage numérique de K valeurs d'entrée au moyen d'un filtre non linéaire, le filtre produisant en tant que valeur de sortie la R^{ième} plus grande valeur à partir des K valeurs d'entrée, où K ≥ R ≥ 1, et les valeurs d'entrée se présentant dans le format en virgule fixe dans une représentation binaire de montant signé, dans laquelle le montant des poids du bit diminue respectivement selon le facteur ½ depuis un bit de poids fort MSB vers un bit de poids faible LSB, et dans laquelle n'apparaissent que les valeurs binaires 0 et 1, dans lequel :
a) pour les différents bits des valeurs d'entrée et de sortie, en commençant par le bit de signe VZB successivement par rapport au poids du bit dont le montant diminue jusqu'au bit de poids faible LSB,
b) pour le bit considéré actuellement respectivement,
- si c'est le bit de signe VZB ou bien si le poids du bit considéré actuellement est négatif, la R^{ième} plus petite valeur binaire vue sur toutes les K valeurs d'entrée est déterminée, qui est 0, si, pour le bit considéré actuellement vu sur toutes les K valeurs d'entrée, la valeur binaire 0 apparaît pas moins de R fois, sinon la R^{ième} plus petite valeur binaire est égale à 1,
- si ce n'est pas le bit de signe VZB, ou bien si le poids du bit considéré actuellement est positif, la R^{ième} plus grande valeur binaire vue sur toutes les K valeurs d'entrée est déterminée, qui est 1, si, pour le bit considéré actuellement vu sur toutes les K valeurs d'entrée la valeur binaire 1 apparaît pas moins de R fois, sinon la R^{ième} plus grande valeur binaire est égale à 0,
c) la valeur binaire ainsi déterminée représentant ensuite la valeur binaire pour le bit considéré actuellement de la R^{ième} plus grande valeur et ainsi de la valeur de sortie,
d) et pour les valeurs d'entrée pour lesquelles la valeur binaire du bit considéré actuellement ne correspond pas à la valeur binaire ainsi déterminée, en tant que valeurs binaires de tous les bits suivants concernant l'ordre de succession selon a) :
- la valeur binaire 0 est utilisée dans la mesure où le bit considéré actuellement est le bit de signe VZB,
- la valeur binaire de ces valeurs d'entrée est utilisée sur le bit considéré actuellement dans la mesure où le bit considéré actuellement n'est pas le bit de signe VZB

4. Procédé de filtrage numérique selon la revendication 3, la médiane d'un nombre impair K de valeurs d'entrée étant produite en tant que valeur de sortie dans une représentation binaire de montant signé, dans lequel ainsi R=(K+1)/2 et dans lequel :
dans l'étape b), il est contrôlé respectivement si, vu sur toutes les K valeurs d'entrée pour le bit considéré actuellement, il apparaît, en tant que valeur binaire, davantage de uns ou de zéros, et
dans l'étape c), la valeur binaire apparaissant plus souvent représente ensuite la valeur binaire pour le bit de la médiane considéré actuellement et donc de la valeur de sortie.

5. Procédé selon une des revendications précédentes, où, pour la réalisation de l'étape d) pour les valeurs d'entrée pour lesquelles la valeur binaire du bit considéré actuellement ne correspond pas à la valeur binaire, définie dans c), de la valeur de sortie, tous les bits suivants sont remplacés en conséquence dans la mémoire et, pour les étapes b) suivantes, il est accédé aux valeurs binaires remplacées en conséquence.

6. Procédé selon une des revendications précédentes, un registre étant prévu, dans lequel, pour chaque valeur d'entrée, il est enregistré
- si, pour la valeur d'entrée respective, pour un bit considéré précédemment, la valeur binaire de cette valeur d'entrée n'a pas déjà correspondu à la valeur binaire, déterminée dans c), de la valeur de sortie et
- si c'est le cas, quelle valeur binaire doit ensuite être utilisée pour cette valeur d'entrée dans l'étape b).

7. Procédé selon une des revendications 1-6, la détermination du nombre d'apparitions de la valeur binaire 1 ou 0 pour le bit considéré actuellement s'effectuant dans la l'étape b) par le biais des K valeurs d'entrée en additionnant de façon binaire les valeurs binaires, et la valeur d'addition correspond ainsi au nombre d'apparitions de la valeur 1 ou K moins la valeur d'addition du nombre d'apparitions de la valeur 0.

8. Procédé selon une des revendications 1-7, qui s'interrompt quand il ne reste dans l'étape d) plus qu'une valeur d'entrée, dont les valeurs binaires ont correspondu, pour tous les bits considérés jusqu'à présent, y compris le bit considéré actuellement, respectivement à la valeur binaire, déterminée dans c), de la valeur de sortie, les bits restants de la valeur de sortie correspondant alors à ceux de cette valeur d'entrée.

9. Filtre numérique comprenant une unité de calcul dans laquelle est enregistré un procédé selon une des revendications précédentes, qui détermine, successivement, à partir de K valeurs numériques voisines d'un signal d'entrée unidimensionnel ou pluridimensionnel de longueur quelconque, une valeur numérique du signal de sortie selon un des procédés précédents, le débit binaire à l'entrée du filtre et le débit binaire à la sortie étant identiques.

10. Filtre numérique comprenant une unité de calcul dans laquelle est enregistré un procédé selon une des revendications 1-8, qui détermine, successivement, à partir de K valeurs numériques voisines d'un signal d'entrée unidimensionnel ou pluridimensionnel de longueur quelconque, une valeur numérique du signal de sortie selon un des procédés précédents, le débit binaire à l'entrée du filtre étant plus grand que le débit binaire à la sortie.

11. Filtre numérique comprenant une unité de calcul dans laquelle est enregistré un procédé selon une des revendications 1-8, qui détermine, successivement, à partir de K valeurs numériques voisines d'un signal d'entrée unidimensionnel ou pluridimensionnel de longueur quelconque, une valeur numérique du signal de sortie selon un des procédés précédents, le débit binaire à l'entrée du filtre étant plus grand, selon le facteur K, que le débit binaire à la sortie, ce qui signifie que chaque valeur du signal d'entrée n'est utilisée qu'une fois.

12. Système de traitement du signal avec un dispositif d'exploration pour l'exploration d'un signal d'entrée, un convertisseur analogique-numérique pour la numérisation du signal d'entrée exploré et un filtre numérique selon une des revendications 9 à 11.

13. Utilisation d'un système de traitement du signal selon la revendication 12 pour empêcher des perturbations transitoires dans un signal d'entrée par un procédé de filtrage de médiane selon une des revendications 2, 4 ou 5-8 en relation avec la revendication 2 ou 4.

14. Utilisation d'un procédé selon une des revendications 1-8 afin de déterminer, pour des signaux numériques dans la plage temporelle ou fréquentielle qui ne présentent un niveau utile au-dessus du niveau de bruit que pour différentes valeur discrètes, un seuil de bruit au-dessus duquel le niveau de signal est interprété et continue à être utilisé en tant que niveau utile.

15. Système optique pour la détection d'objets dans lequel des impulsions lumineuses, de préférence dans la plage de longueurs d'ondes infrarouges, sont émises, avec un système de traitement du signal selon la revendication 12.

16. Système radar pour la détection d'objets avec un système de traitement du signal selon la revendication 12.

17. Système ultrasonore pour la détection d'objets avec un système de traitement du signal selon la revendication 12.
